# EUROPEAN PATENT SPECIFICATION

(11) **EP 2 514 798 B1**
(45) Date of publication and mention of the grant of the patent: **28.09.2016**
(21) Application number: 10837767.2
(22) Date of filing: 14.10.2010
(51) Int. Cl.: C09K 11/06, H01L 51/54

(54) **COMPOUND FOR ORGANIC PHOTOELECTRIC DEVICE AND ORGANIC PHOTOELECTRIC DEVICE INCLUDING SAME**
VERBINDUNG FÜR ORGANISCHE PHOTOELEKTRISCHE VORRICHTUNG UND ORGANISCHE PHOTOELEKTRISCHE VORRICHTUNG DAMIT
COMPOSÉ POUR DISPOSITIF PHOTOÉLECTRIQUE ORGANIQUE ET DISPOSITIF PHOTOÉLECTRIQUE ORGANIQUE LE COMPRENANT

(30) Priority: 16.12.2009 KR 20090125506
(43) Date of publication of application: 24.10.2012
(73) Proprietor: Cheil Industries Inc., Kumi-city, Kyungsangbuk-do 730-030 (KR)
(72) Inventor: JUNG, Sung-Hyun, Uiwang-si Gyeonggi-do 437-711 (KR); KANG, Myeong-Soon, Uiwang-si Gyeonggi-do 437-711 (KR); JUNG, Ho-Kuk, Uiwang-si Gyeonggi-do 437-711 (KR); KIM, Nam-Soo, Uiwang-si Gyeonggi-do 437-801 (KR); LEE, Nam-Heon, Uiwang-si Gyeonggi-do 437-711 (KR); KANG, Eui-Su, Uiwang-si Gyeonggi-do 437-711 (KR); KANG, Dong-Min, Uiwang-si Gyeonggi-do 437-711 (KR); CHAE, Mi-Young, Uiwang-si Gyeonggi-do 437-711 (KR)
(74) Representative: Michalski Hüttermann & Partner Patentanwälte mbB
(86) International application number: PCT/KR2010/007059
(87) International publication number: WO 2011/074770

(56) References cited:
- WO-A1-2005/105950
- WO-A1-2009/142867
- JP-A- 2009 184 987
- KR-A- 20060 021 143
- KR-A- 20090 008 737
- US-A1- 2007 257 600
- J A BARTH ET AL: "Reactions of Acylium Salts with Aryl Nitriles. A Convenient Synthesis of Aryl Substituted Bis-and Tris-1 3,5-Oxadiazinium Salts", JOURNAL F. PRAKT. CHEMIE. BAND, vol. 333, no. 2, 1 January 1991 (1991-01-01), pages 303-311, XP055105774, DOI: 10.1002/prac.19913330216

## Description

### BACKGROUND OF THE INVENTION

### (a) Field of the Invention

A compound for an organic photoelectric device being capable of providing an organic photoelectric device having excellent life-span, efficiency, electrochemical stability, and thermal stability, and an organic photoelectric device including the same are related.

### (b) Description of the Related Art

An organic photoelectric device is, in a broad sense, a device for transforming photo-energy to electrical energy, or conversely, a device for transforming electrical energy to photo-energy.

An organic photoelectric device may be classified as follows in accordance with its driving principles. A first organic photoelectric device is an electron device driven as follows: excitons are generated in an organic material layer by photons from an external light source; the excitons are separated into electrons and holes; and the electrons and holes are transferred to different electrodes as a current source (voltage source).

A second organic photoelectric device is an electron device driven as follows: a voltage or a current is applied to at least two electrodes to inject holes and/or electrons into an organic material semiconductor positioned at an interface of the electrodes; and the device is driven by the injected electrons and holes.

Examples of an organic photoelectric device includes an organic light emitting diode, an organic solar cell, an organic photo conductor drum, and an organic transistor, and it requires a hole injecting or transporting material, an electron injecting or transporting material, or a light emitting material.

Particularly, an organic photoelectric device (organic light emitting diodes, OLED) has recently drawn attention due to an increase in demand for flat panel displays. In general, organic light emission refers to transformation of electrical energy to photo-energy.

Such an organic photoelectric device transforms electrical energy into light by applying current to an organic light emitting material. It has a structure in which a functional organic material layer is interposed between an anode and a cathode. The organic material layer includes a multi-layer including different materials, for example a hole injection layer (HIL), a hole transport layer (HTL), an emission layer, an electron transport layer (ETL), and an electron injection layer (EIL), in order to improve efficiency and stability of an organic photoelectric device.

In such an organic photoelectric device, when a voltage is applied between an anode and a cathode, holes from the anode and electrons from the cathode are injected to an organic material layer and recombined to generate excitons having high energy. The generated excitons generate light having certain wavelengths while shifting to a ground state.

In J A BARTH ET AL: "Reaction of Acylium Salts with Aryl Nitriles. A Convenient Synthesis of Aryl Substituted Bis- and Tris-1,3,5-Oxadiazinium Salts", Journal F. Prakt. Chemie. Band, vol. 333, no 2, 1 January 1991 (1991-01-01), pages 303-311; charged aryl substituted tris-1,3,5-Oxadiazinium salts are described.

US 2007/257600 A1 refers to an organic electroluminescent device having a multilayer structure including at least emitting layer and electron-transporting layer between cathodes and and anode, the triplet energy gap (Eg^{T}) of a host material forming emitting layer being 2.52 eV or more and 3.7 eV or less, an electron-transporting material forming electron-transporting layer being different from the host material, and having hole-transporting properties, and emitting layer including a phosphorescent metal complex compound containing a heavy metal.

JP 2009 184987 refers to a new pyrimidine-based or triazine-based derivative, an electron transport material comprising the derivative and an organic electroluminescent element including the derivative.

In 1987, Eastman Kodak, Inc. firstly developed an organic light emitting diode including a low molecular aromatic diamine and aluminum complex as an emission layer forming material (Applied Physics Letters. 51, 913, 1987). C.W Tang et al. firstly disclosed a practicable device as an organic light emitting diode in 1987 (Applied Physics Letters, 51 12, 913-915, 1987).

According to the reference, the organic layer has a structure in which a thin film (hole transport layer (HTL)) of a diamine derivative and a thin film of tris(8-hydroxy-quinolate)aluminum (Alq₃) are laminated.

Recently, it has become known that a phosphorescent light emitting material can be used for a light emitting material of an organic light emitting diode in addition to the fluorescent light emitting material (D. F. O'Brien et al., Applied Physics Letters, 74(3), 442-444, 1999; M. A. Baldo et al., Applied Physics letters, 75(1), 4-6, 1999). Such a phosphorescent material emits lights by transiting the electrons from a ground state to an exited state, non-radiance transiting of a singlet exciton to a triplet exciton through intersystem crossing, and transiting a triplet exciton to a ground state to emit light.

As described above, in an organic light emitting diode, an organic material layer includes a light emitting material and a charge transport material, for example a hole injection material, a hole transport material, an electron transport material, an electron injection material, and so on.

The light emitting material is classified as blue, green, and red light emitting materials according to emitted colors, and yellow and orange light emitting materials to emit colors approaching natural colors.

When one material is used as a light emitting material, a maximum light emitting wavelength is shifted to a long wavelength or color purity decreases because of interactions between molecules, or device efficiency decreases because of a light emitting quenching effect. Therefore, a host/dopant system is included as a light emitting material in order to improve color purity and increase luminous efficiency and stability through energy transfer.

In order to implement excellent performance of an organic photoelectric device, a material constituting an organic material layer, for example a hole injection material, a hole transport material, a light emitting material, an electron transport material, an electron injection material, and a light emitting material such as a host and/or a dopant, should be stable and have good efficiency. However, development of an organic material layer forming material for an organic light emitting diode has thus far not been satisfactory and thus there is a need for a novel material. This material development is also required for other organic photoelectric devices.

### SUMMARY OF THE INVENTION

A compound for an organic photoelectric device that may act as an electron injection and/or transport material, and also act as a light emitting host along with an appropriate dopant, is provided.

An organic photoelectric device having excellent life span, efficiency, driving voltage, electrochemical stability, and thermal stability is provided.

According to one aspect of the present invention, a compound for an organic photoelectric device represented by the following Chemical Formula 1 or 2 is provided.

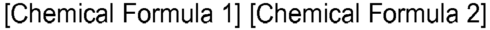

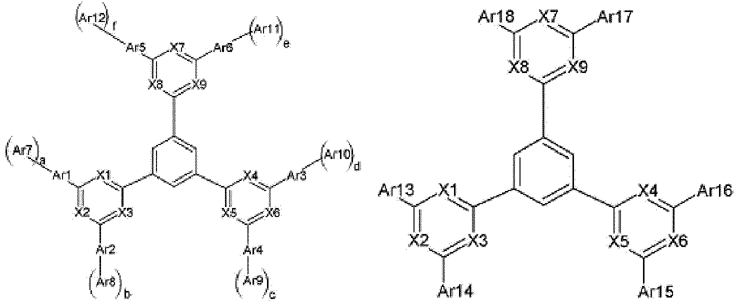

In Chemical Formulae 1 and 2, X1 to X9 are the same or different and independently a N or CR, wherein R is selected from the group consisting of hydrogen, a C1 to C30 alkyl group, and a C6 to C30 aryl group, at least two of X1 to X3 are a N, at least one of X4 to X6 is a N, and at least one of X7 to X9 is a N, in Chemical Formula 1, Ar1 to Ar6 are the same or different and are independently selected from the group consisting of a substituted or unsubstituted C6 to C30 arylene group, a substituted or unsubstituted C3 to C30 heteroarylene group, a substituted or unsubstituted C6 to C30 arylaminylene group, a substituted or unsubstituted carbazolylene group, and a substituted or unsubstituted fluorenylene group, Ar7 to Ar12 are the same or different and are independently selected from the group consisting of a substituted or unsubstituted C6 to C30 aryl group or a substituted or unsubstituted C3 to C30 heteroaryl group, and a, b, c, d, e, and f are the same or different and are independently an integer ranging from 1 or 2, and in Chemical Formula 2, Ar13 to Ar18 are the same or different and are independently selected from the group consisting of a substituted or unsubstituted C6 to C30 aryl group, a substituted or unsubstituted C3 to C30 heteroaryl group, a substituted or unsubstituted C6 to C30 arylamine group, a substituted or unsubstituted carbazolyl group, and a substituted or unsubstituted fluorenyl group.

According to one exemplary embodiment, at least two of X4 to X6 are a N.

According to one exemplary embodiment, the compound for an organic photoelectric device represented by the above Chemical Formula 1 or 2 may be a compound where X2, X3, X5, X6, and X7 is N, or a compound where X2, X3, X5, X6, and X9 is N.

According to one exemplary embodiment, the compound for an organic photoelectric device represented by the above Chemical Formula 1 or 2 may be selected from the group consisting of a compound where X2, X3, X5, X6, X7, and X9 is N; a compound where X2, X3, X5, X6, X8, and X9 is N; a compound where X1, X3, X4, X5, X8, and X9 is N; and a compound where X1, X3, X4, X5, X7, and X9 is N.

According to one exemplary embodiment, the compound for an organic photoelectric device represented by the above Chemical Formula 1 or 2 may be a compound where X2, X6, X7, and X9 is N or a compound where X3, X5, X7, and X9 is N.

According to one exemplary embodiment, the compound for an organic photoelectric device represented by the above Chemical Formula 1 or 2 may be a compound where X2, X6, X7, X8, and X9 is N or a compound where X3, X5, X7, X8, and X9 is N.

According to one exemplary embodiment, the compound for an organic photoelectric device represented by the above Chemical Formula 1 or 2 may be a compound where X2, X3, X5, X6, X7, X8, and X9 is N, or a compound where X1, X3, X4, X5, X7, X8, and X9 is N.

According to one exemplary embodiment, in Chemical Formula 1, Ar7 to Ar12 are the same or different and are independently selected from the group consisting of a phenyl group, a biphenyl group, a terphenyl group, a stilbenyl group, a naphthyl group, an anthracenyl group, a phenanthrenyl group, a pyrenyl group, and a perylenyl group, and Ar1 to Ar6 are the same or different and are independently selected from the group consisting of a phenylene group, a biphenylene group, a terphenylene group, a stilbenylene group, naphthylene group, an anthracenylene group, a phenanthrenylene group, a pyrenylene group, and a perylenylene group, and in Chemcial Formula 2, Ar13 to Ar18 are the same or different and are independently selected from the group consisting of a phenyl group, a biphenyl group, a terphenyl group, a stilbenyl group, a naphthyl group, an anthracenyl group, a phenanthrenyl group, a pyrenyl group, and a perylenyl group.

According to one exemplary embodiment, in Chemical Formula 1, Ar7 to Ar12 are the same or different and are independently selected from the group consisting of a thiophenyl group, a furanyl group, a pyrrolyl group, an imidazolyl group, a thiazolyl group, an oxazolyl group, an oxadiazolyl group, a triazolyl group, a pyridinyl group, a pyradazinyl group, a quinolinyl group, an isoquinolinyl group, an acridinyl group, an imidazopyridinyl group, an imidazopyrimidinyl group, a benzoquinolinyl group, and a phenanthrolinyl group, and in Chemical Formula 2, Ar13 to Ar18 are the same or different and are independently selected from the group consisting of a thiophenyl group, a furanyl group, a pyrrolyl group, an imidazolyl group, a thiazolyl group, an oxazolyl group, an oxadiazolyl group, a triazolyl group, a pyridinyl group, a pyradazinyl group, a quinolinyl group, an isoquinolinyl group, an acridinyl group, an imidazopyridinyl group, an imidazopyrimidinyl group, a benzoquinolinyl group, and a phenanthrolinyl group.

According to another aspect of the present invention, a compound for an organic photoelectric device represented by one of the following Chemical Formulae 3 to 33 are provided.

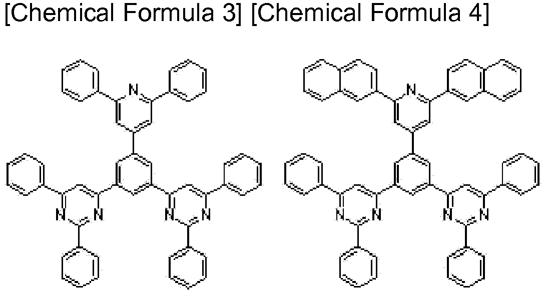

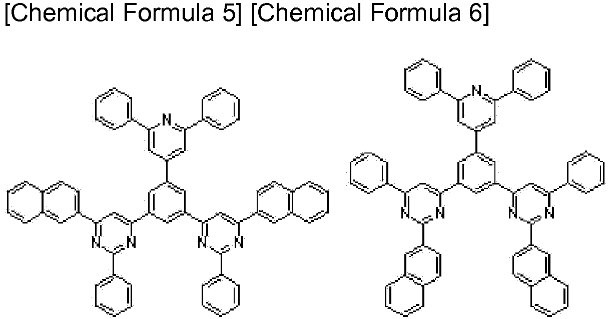

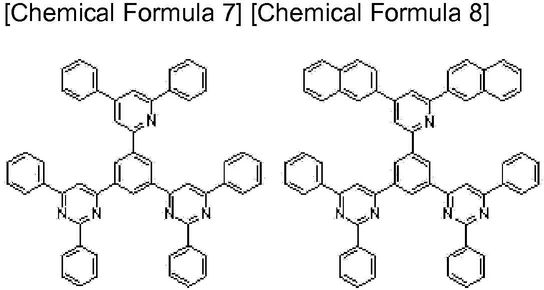

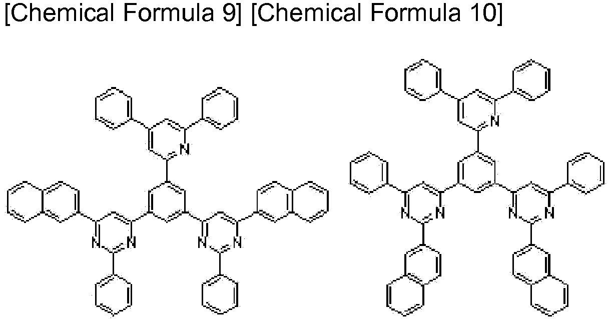

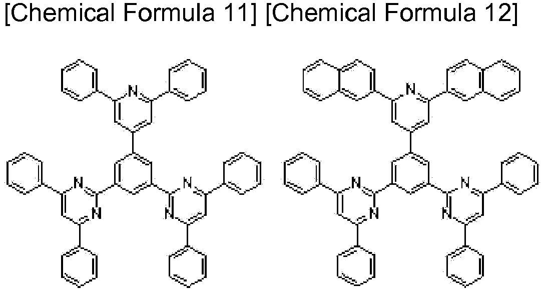

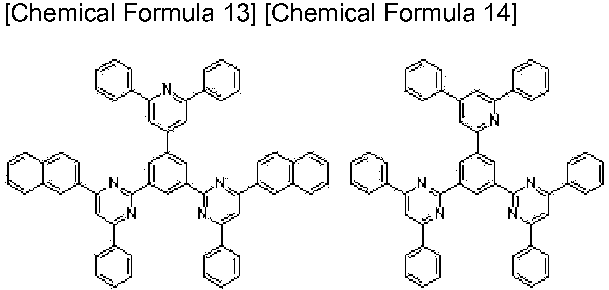

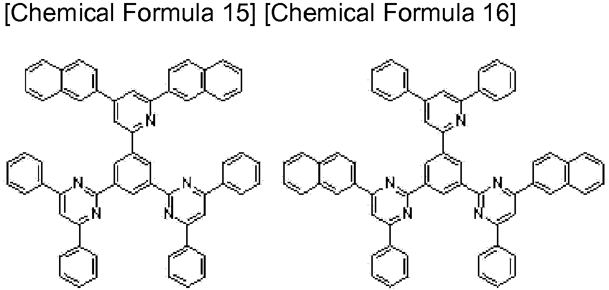

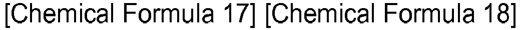

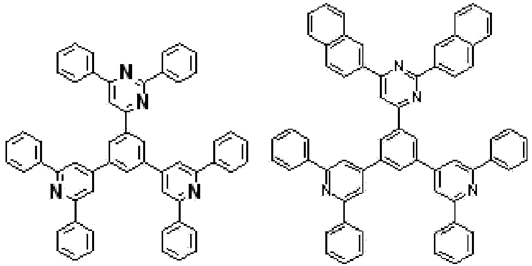

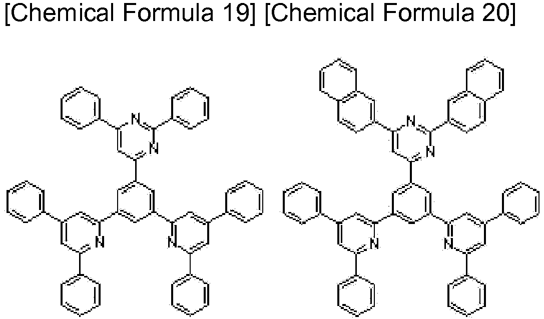

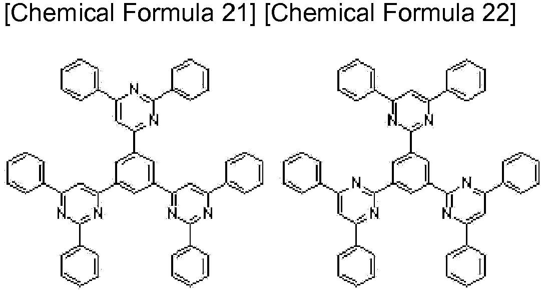

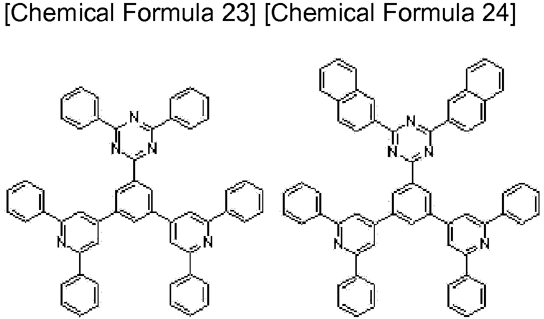

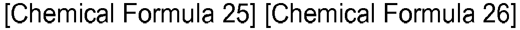

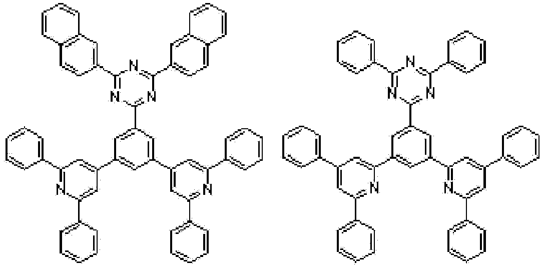

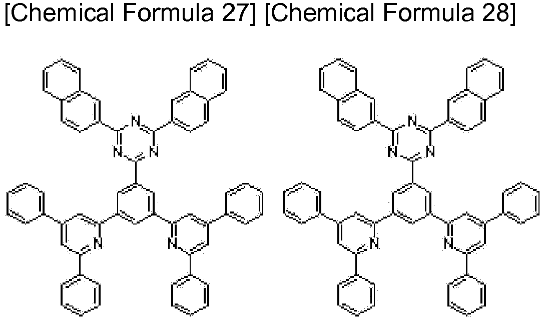

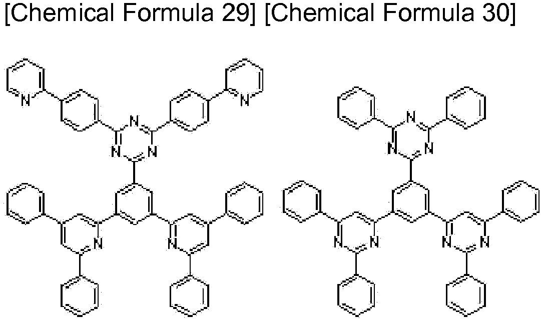

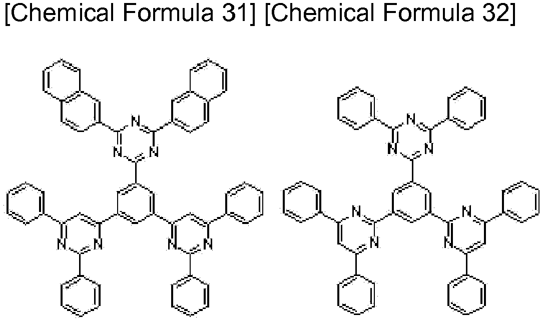

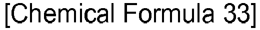

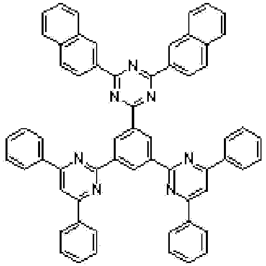

According to another aspect of the present invention, provided is an organic photoelectric device that includes an anode, a cathode, and at least one or more organic thin layers between the anode and the cathode, wherein at least one of the organic thin layer includes the compound for an organic photoelectric device.

The organic thin layer may be selected from the group consisting of an emission layer, a hole transport layer (HTL), a hole injection layer (HIL), an electron transport layer (ETL), an electron injection layer (EIL), a hole blocking layer, and a combination thereof.

The compound for an organic photoelectric device may be included in an electron transport layer (ETL) or an electron injection layer (EIL).

The compound for an organic photoelectric device may be included in an emission layer.

The compound for an organic photoelectric device may be used as a phosphorescent or fluorescent host material in an emission layer.

The compound for an organic photoelectric device may be used as a fluorescent blue dopant material in an emission layer.

The organic photoelectric device may be selected from the group consisting of an organic light emitting diode, an organic solar cell, an organic transistor, an organic photo conductor drum, and an organic memory device.

According to another aspect of the present invention, a display devie including the organic photoelectric device is provided.

An organic photoelectric device having life-span characteristic and high luminous efficiency at a low driving voltage may be provided due to excellent electrochemical and thermal stability.

### BRIEF DESCRIPTION OF THE DRAWINGS

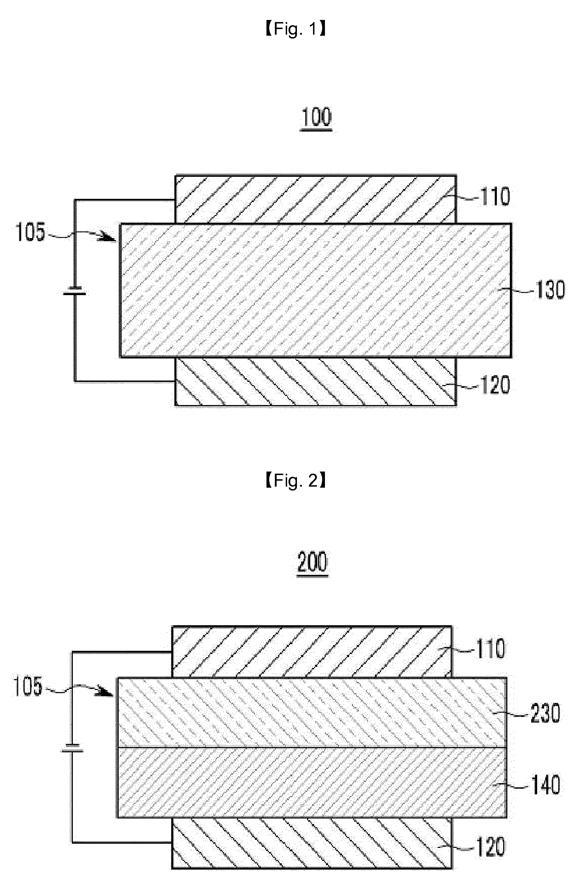

FIGS. 1 to 5 are cross-sectional views showing organic photoelectric devices including compounds for an organic photoelectric device according to various embodiments of the present invention.

### <Description of Reference Numerals Indicating Primary Elements in the Drawings>

100 : organic photoelectric device 110 : cathode
120 : anode 105 : organic thin layer
130 : emission layer 140 : hole transport layer (HTL)
150 : electron transport layer (ETL) 160 : electron injection layer (EIL)
170 : hole injection layer (HIL) 230 : emission layer + electron transport layer (ETL)

### DETAILED DESCRIPTION

Exemplary embodiments of the present invention will hereinafter be described in detail. However, these embodiments are only exemplary, and the present invention is not limited thereto.

Through the specification, the term "substituted" refers to one substituted with a C1 to C30 alkyl group, a C1 to C10 alkylsilyl group, a C3 to C30 cycloalkyl group, a C6 to C30 aryl group, a C1 to C10 alkoxy group, a fluoro group, a C1 to C10 trifluoroalkyl group such as a trifluoromethyl group, and the like, or a cyano group.

Through the specification, the term "hetero" refers to one including 1 to 3 heteroatoms selected from the group consisting of N and carbons in the rest thereof, in one ring.

Through the specification, the term "a combination thereof" refers to at least two substituents bound to each other by a linker or at least two substituents fused to each other.

Through the specification, when a definition is not otherwise provided, the term "alkyl" refers to an aliphatic hydrocarbon group. The alkyl may be a "saturated alkyl group" that does not include any alkene or alkyne. Alternatively, the alkyl may be an "unsaturated alkyl group" that includes at least one alkene or alkyne. The term "alkene" refers to a group in which at least two carbon atoms are bound in at least one carbon-carbon double bond, and the term "alkyne" refers to a group in which at least two carbon atoms are bound in at least one carbon-carbon triple bond. Regardless of being saturated or unsaturated, the alkyl may be branched, linear, or cyclic.

The alkyl group may have 1 to 20 carbon atoms. The alkyl group may be a medium-sized alkyl having 1 to 10 carbon atoms. The alkyl group may be a lower alkyl having 1 to 6 carbon atoms.

For example, a C1 to C4 alkyl may have 1 to 4 carbon atoms and may be selected from the group consisting of methyl, ethyl, propyl, iso-propyl, n-butyl, iso-butyl, sec-butyl, and t-butyl.

Examples of an alkyl group may be selected from the group consisting of methyl, ethyl, propyl, isopropyl, butyl, isobutyl, t-butyl, pentyl, hexyl, ethenyl, propenyl, butenyl, cyclopropyl, cyclobutyl, cyclopentyl, cyclohexyl, or the like, which may be individually and independently substituted.

The term "aryl" refers to an aryl group including a carbocyclic aryl (e.g., phenyl) having at least one ring having a covalent pi electron system. The term also refers to monocyclic or fused polycyclic (i.e., rings sharing adjacent pairs of carbon atoms) groups. In addition, this term also refers to a spiro compound having a contact point of one carbon.

The term "heteroaryl" refers to a heterocyclic aryl group including a carbocyclic aryl (e.g., pyridine) having at least one ring having a covalent pi electron system. The term also refers to monocyclic or fusion ring polycyclic (i.e., groups sharing adjacent pairs of carbon atoms) groups. In addition, the term also refers to a spiro compound having a contact point of one carbon.

According to one embodiment, the compound for an organic photoelectric device may have a structure that three heteroaryl groups are bound to a benzene core structure. The three substiuents may be bound at the positions of 1, 3, and 5 of the core benzene.

In addition, since the compound for an organic photoelectric device having the various energy bands may be synthesized by introducing the various substituents to the core part and the two substituents, compounds satisfying the conditions required for an emission layer as well as an electron injection layer (EIL) and a transport layer may be provided.

By using the compound having an appropriate energy level depending upon the substituents of compound in an organic photoelectric device, the electron transport capability may be enhanced to provide excellent effects on the efficiency and the driving voltage; and the life-span characteristics may be improved when driving the organic photoelectric device since it has the excellent electrochemical and thermal stability.

According to one embodiment of the present invention, a compound for an organic photoelectric device represented by the following Chemical Formula 1 or 2 is provided.

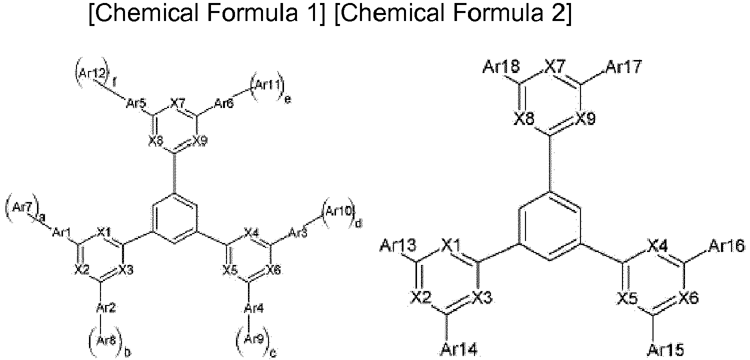

In Chemical Formulae 1 and 2, X1 to X9 are the same or different and independently a N or CR, wherein R is selected from the group consisting of hydrogen, a C1 to C30 alkyl group, and a C6 to C30 aryl group, at least two of X1 to X3 are a N, at least one of X4 to X6 is a N, and at least one of X7 to X9 is a N.

The heteroaryl group, which is a substituent of the core benzene, may be totally present in three. One of the heteroaryl groups may include at least two N.

Various combinations may be realized depending upon the number of N included in each heteroaryl group. The characteristics of the compound may be changed upon each combination, and each combination may be selected according to required characteristics.

For example, at least two of X4 to X6 are a N. Thereby, two heteroaryl groups among three heteroaryl groups may include at least two N.

Examples of various combinations are as follows:

Acompound where X2, X3, X5, X6, and X7 is N, or a compound where X2, X3, X5, X6, and X9 is N may be provided

Acompound where X2, X3, X5, X6, X7, and X9 is N; a compound where X2, X3, X5, X6, X8, and X9 is N; a compound where X1, X3, X4, X5, X8, and X9 is N; and a compound where X1, X3, X4, X5, X7, and X9 is N may be provided.

Acompound where X2, X6, X7, and X9 is N or a compound where X3, X5, X7, and X9 is N may be provided

A ompound where X2, X6, X7, X8, and X9 is N or a compound where X3, X5, X7, X8, and X9 is N may be provided.

A compound where X2, X3, X5, X6, X7, X8, and X9 is N, or a compound where X1, X3, X4, X5, X7, X8, and X9 is N may be provided.

It is preferable that the heteroatom is N.
in Chemical Formula 1, Ar1 to Ar6 are the same or different and independently selected from the group consisting of a substituted or unsubstituted C6 to C30 arylene group, a substituted or unsubstituted C3 to C30 heteroarylene group, a substituted or unsubstituted C6 to C30 arylaminylene group, a substituted or unsubstituted carbazolylene group, and a substituted or unsubstituted fluorenylene group.

The light emission may be controlled in the visible region by adjusting the π conjugation lengths of Ar1 to Ar6. Thereby, the compound may be very usefully applied to an emission layer of an organic photoelectric device. But, when the number of carbon is over the range, the effects as a device may be insufficient.

Examples of Ar1 to Ar6 may be a phenylene group, a biphenylene group, a terphenylene group, a stilbenylene group, a naphthylene group, an anthracenylene group, a phenanthrenyl group, a pyrenyl group, a perylenyl group, and the like.
in Chemical Formula 1, Ar7 to Ar12 are the same or different and independently a substituted or unsubstituted C6 to C30 aryl group or a substituted or unsubstituted C3 to C30 heteroaryl group, and a, b, c, d, e and f are the same or different and are independently an integer of 1 or 2.

The substituent-bound structure has excellent thermal stability and resistance to the oxidation, so the life-span characteristics of organic photoelectric device may be improved.

The electron transport capacity of compound may be controlled depending upon the kind of substituent. In addition, it may provide the compound with a bulk structure, so the crystallinity may be decreased. When the crystalinity of compound is decreased, the life-span of device may be prolonged.

Examples of Ar7 to Ar12 may be a phenyl group, a biphenyl group, a terphenyl group, a stilbenyl group, a naphthyl group, an anthracenyl group, a phenanthrenyl group, a pyrenyl group, or a perylenyl group.

Another examples of Ar7 to Ar12 may be a thiophenyl group, a furanyl group, a pyrrolyl group, an imidazolyl group, a thiazolyl group, an oxazolyl group, an oxadiazolyl group, a triazolyl group, a pyridinyl group, a pyradazinyl group, a quinolinyl group, an isoquinolinyl group, an acridinyl group, an imidazopyridinyl group, an imidazopyrimidinyl group, a benzoquinolinyl group, or a phenanthrolinyl group.

In Chemical Formula 2, Ar13 to Ar18 are the same or different and are independently selected from the group consisting of a substituted or unsubstituted C6 to C30 aryl group, a substituted or unsubstituted C3 to C30 heteroaryl group, a substituted or unsubstituted C6 to C30 arylamine group, a substituted or unsubstituted carbazolyl group, and a substituted or unsubstituted fluorenyl group.

The substituent-bound structure has excellent thermal stability and resistance to the oxidation, so the life-span characteristics of organic photoelectric device may be improved.

The electron transport capacity of compound may be controlled depending upon the kind of substituent. In addition, it may provide the compound with a bulk structure, so the crystallinity may be decreased. When the crystallinity of compound is decreased, the life-span of device may be prolonged.

Examples of Ar13 to Ar18 may be a phenyl group, a biphenyl group, a terphenyl group, a stilbenyl group, a naphthyl group, an anthracenyl group, a phenanthrenyl group, a pyrenyl group, a perylenyl group, and the like.

Another examples of Ar13 to Ar18 may be a thiophenyl group, a furanyl group, a pyrrolyl group, an imidazolyl group, a thiazolyl group, an oxazolyl group, an oxadiazolyl group, a triazolyl group, a pyridinyl group, a pyradazinyl group, a quinolinyl group, an isoquinolinyl group, an acridinyl group, an imidazopyridinyl group, an imidazopyrimidinyl group, a benzoquinolinyl group, a phenanthrolinyl group, and the like.

The compound for an organic photoelectric device may be represented by the following Chemical Formulae 3 to 33. However, the present invention is not limited to the following compounds.

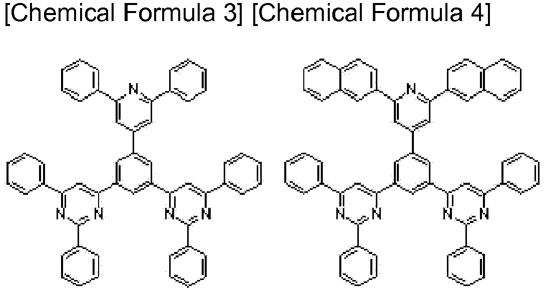

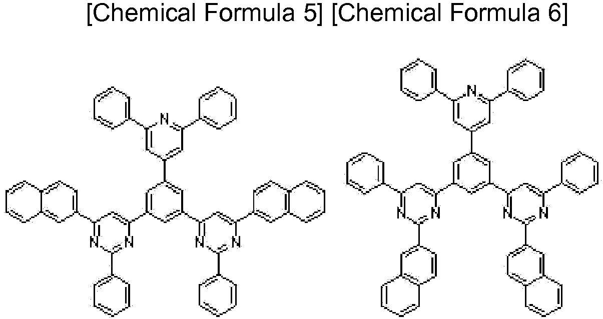

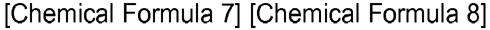

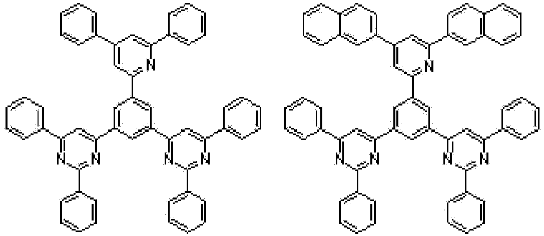

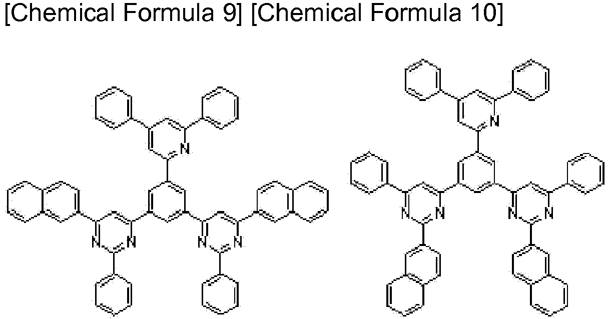

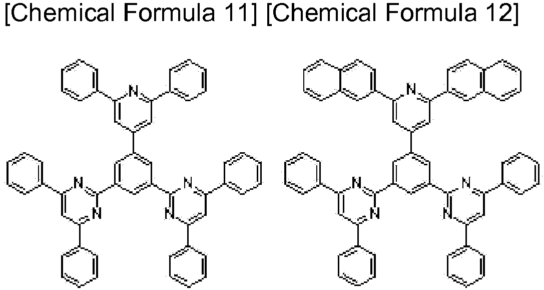

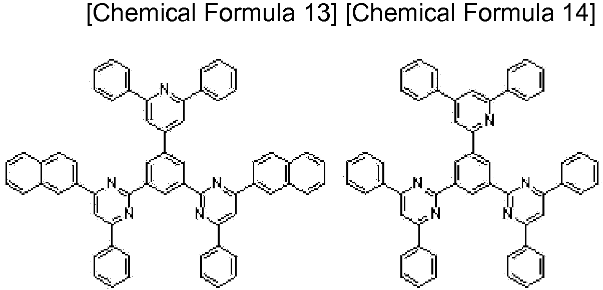

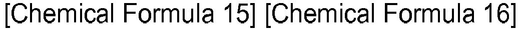

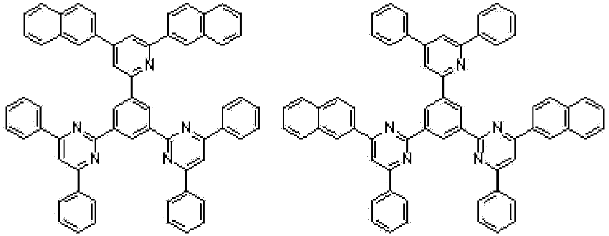

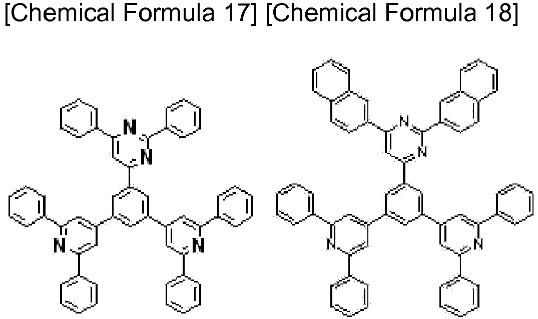

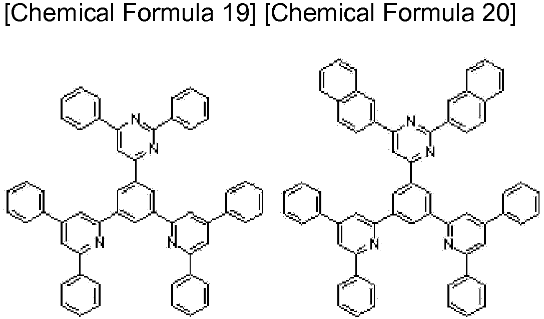

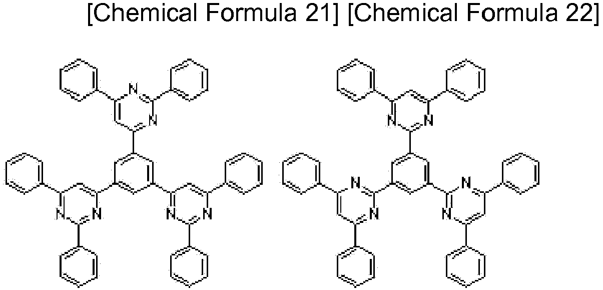

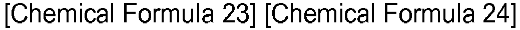

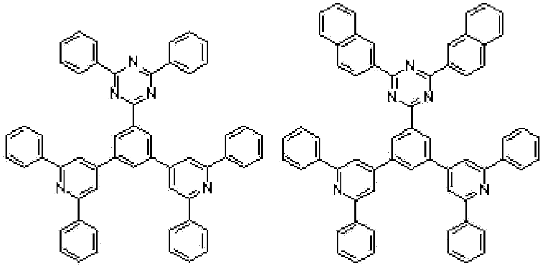

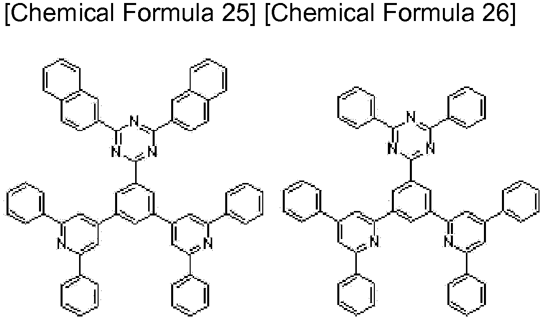

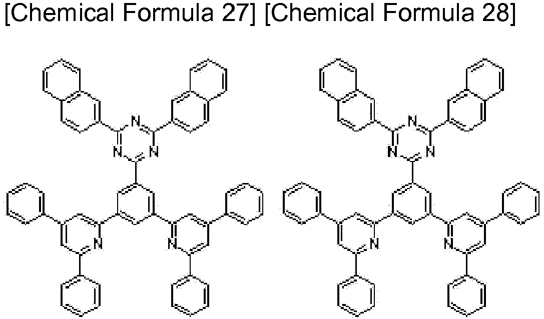

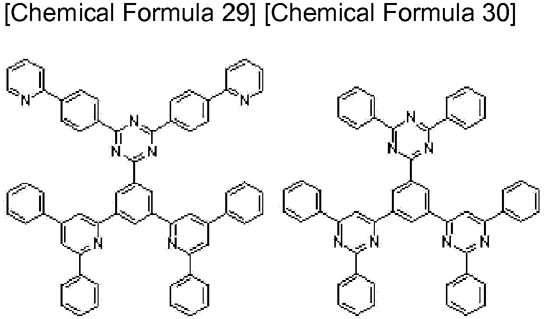

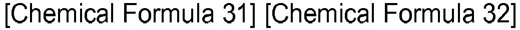

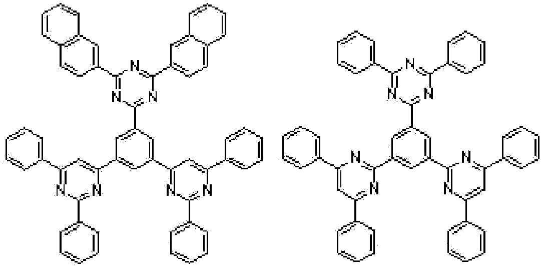

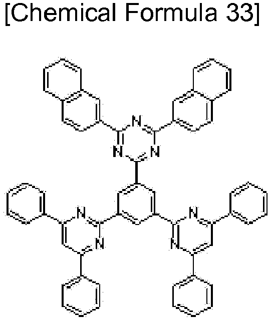

The compound for an organic photoelectric device including the above compound has a glass transition temperature of higher than or equal to 110°C or and a thermal decomposition temperature of higher than or equal to 400°C, so as to improve thermal stability. Thereby, an organic photoelectric device having a high efficiency may be realized.

The compound for an organic photoelectric device including the above compound may play a role for emitting light or injecting and/or transporting electrons, and it may act as a light emitting host together with a suitable dopant. The compound for an organic photoelectric device may be applied as a phosphorescent or fluorescent host material, a blue light emitting dopant material, or an electron transport material.

Since the compound for an organic photoelectric device according to one embodiment is used for an organic thin layer, it may improve the life-span characteristic, efficiency characteristic, electrochemical stability, and thermal stability of an organic photoelectric device and decrease the driving voltage.

Therefore, according to another embodiment, an organic photoelectric device is provided that includes the compound for an organic photoelectric device. The organic photoelectric device may include an organic light emitting diode, an organic solar cell, an organic transistor, an organic photosensitive drum, an organic memory device, or the like. For example, the compound for an organic photoelectric device according to one embodiment may be included in an electrode or an electrode buffer layer in the organic solar cell to improve the quantum efficiency, and it may be used as an electrode material for a gate electrode, a source-drain electrode, or the like in the organic transistor.

Hereinafter, a detailed description relating to the organic photoelectric device will be provided.

According to another embodiment of the present invention, the organic photoelectric device includes an anode, a cathode, and at least one organic thin layer interposed between the anode and the cathode, wherein the at least one organic thin layer may provide an organic photoelectric device including the compound for an organic photoelectric device according to one embodiment.

The organic thin layer that may include the compound for an organic photoelectric device may include a layer selected from the group consisting of an emission layer, a hole transport layer (HTL), a hole injection layer (HIL), an electron transport layer (ETL), an electron injection layer (EIL), a hole blocking film, and a combination thereof. The at least one layer includes the compound for an organic photoelectric device according to one embodiment. Particularly, the electron transport layer (ETL) or the electron injection layer (EIL) may include the compound for an organic photoelectric device according to one embodiment. In addition, when the compound for an organic photoelectric device is included in the emission layer, the compound for an organic photoelectric device may be included as a phosphorescent or fluorescent host, and particularly, as a fluorescent blue dopant material.

FIGS. 1 to 5 are cross-sectional views showing an organic photoelectric device including the compound for an organic photoelectric device according to one embodiment of the present invention.

Referring to FIGS. 1 to 5, organic photoelectric devices 100, 200, 300, 400, and 500 according to one embodiment include at least one organic thin layer 105 interposed between an anode 120 and a cathode 110.

The anode 120 includes an anode material laving a large work function to help hole injection into an organic thin layer. The anode material includes: a metal such as nickel, platinum, vanadium, chromium, copper, zinc, and gold, or alloys thereof; a metal oxide such as zinc oxide, indium oxide, indium tin oxide (ITO), and indium zinc oxide (IZO); a combined metal and oxide such as ZnO:Al or SnO₂:Sb; or a conductive polymer such as poly(3-methylthiophene), poly[3,4-(ethylene-1,2-dioxy)thiophene] (PEDT), polypyrrole, and polyaniline, but is not limited thereto. It is preferable to include a transparent electrode including indium tin oxide (ITO) as an anode.

The cathode 110 includes a cathode material having a small work function to help electron injection into an organic thin layer. The cathode material includes: a metal such as magnesium, calcium, sodium, potassium, titanium, indium, yttrium, lithium, gadolinium, aluminum, silver, tin, and lead, or alloys thereof; or a multi-layered material such as LiF/Al, Liq/Al, LiO₂/Al, LiF/Ca, LiF/Al, and BaF₂/Ca, but is not limited thereto. It is preferable to include a metal electrode including aluminum as a cathode.

Referring to FIG. 1, the organic photoelectric device 100 includes an organic thin layer 105 including only an emission layer 130.

Referring to FIG. 2, a double-layered organic photoelectric device 200 includes an organic thin layer 105 including an emission layer 230 including an electron transport layer (ETL), and a hole transport layer (HTL) 140. As shown in FIG. 2, the organic thin layer 105 includes a double layer of the emission layer 230 and hole transport layer (HTL) 140. Referring to FIG. 2, a double-layered organic photoelectric device 200 includes an organic thin layer 105 including an emission layer 230 including an electron transport layer (ETL), and a hole transport layer (HTL) 140.

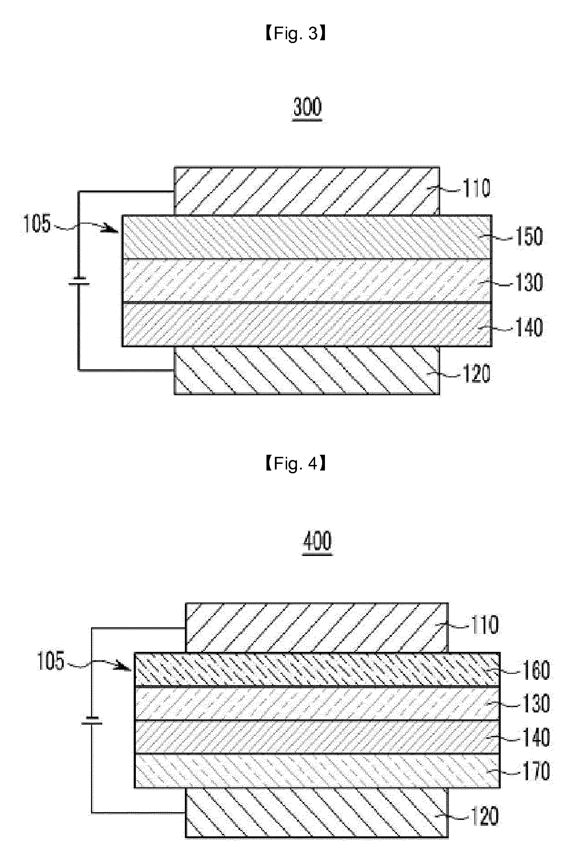

Referring to FIG. 3, a three-layered organic photoelectric device 300 includes an organic thin layer 105 including an electron transport layer (ETL) 150, an emission layer 130, and a hole transport layer (HTL) 140. The emission layer 130 is independently installed, and layers having an excellent electron transporting property or an excellent hole transporting property are separately stacked.

As shown in FIG. 4, a four-layered organic photoelectric device 400 includes an organic thin layer 105 including an electron injection layer (EIL) 160, an emission layer 130, a hole transport layer (HTL) 140, and a hole injection layer (HIL) 170 for binding with the cathode of ITO.

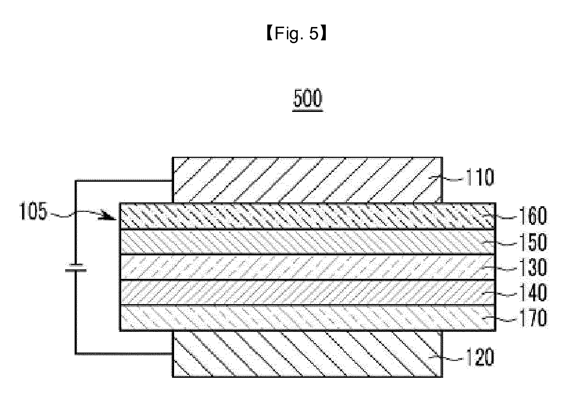

As shown in FIG. 5, a five layered organic photoelectric device 500 includes an organic thin layer 105 including an electron transport layer (ETL) 150, an emission layer 130, a hole transport layer (HTL) 140, and a hole injection layer (HIL) 170, and further includes an electron injection layer (EIL) 160 to achieve a low voltage.

In FIGS. 1 to 5, the organic thin layer 105 including at least one selected from the group consisting of an electron transport layer (ETL) 150, an electron injection layer (EIL) 160, emission layers 130 and 230, a hole transport layer (HTL) 140, a hole injection layer (HIL) 170, and combinations thereof includes a compound for an organic photoelectric device. The compound for the organic photoelectric device may be used for an electron transport layer (ETL) 150 including the electron transport layer (ETL) 150 or electron injection layer (EIL) 160. When it is used for the electron transport layer (ETL), it is possible to provide an organic photoelectric device having a more simple structure because it does not require an additional hole blocking layer (not shown).

Furthermore, when the compound for an organic photoelectric device is included in the emission layers 130 and 230, the material for the organic photoelectric device may be included as a phosphorescent or fluorescent host or a fluorescent blue dopant.

The organic photoelectric device may be fabricated by: forming an anode on a substrate; forming an organic thin layer in accordance with a dry coating method such as evaporation, sputtering, plasma plating, and ion plating or a wet coating method such as spin coating, dipping, and flow coating; and providing a cathode thereon.

Another embodiment of the present invention provides a display device including the organic photoelectric device according to the above embodiment.

Hereinafter, the embodiments are illustrated in more detail with reference to examples. However, the following are exemplary embodiments and are not limiting.

### (Preparation of compound for an organic photoelectric device)

### Example 1: Synthesis of the compound represented by Chemical Formula 3

As an example of the present invention, the compound represented by above formula 3 is synthesized in accordance with the following Reaction Scheme 1.

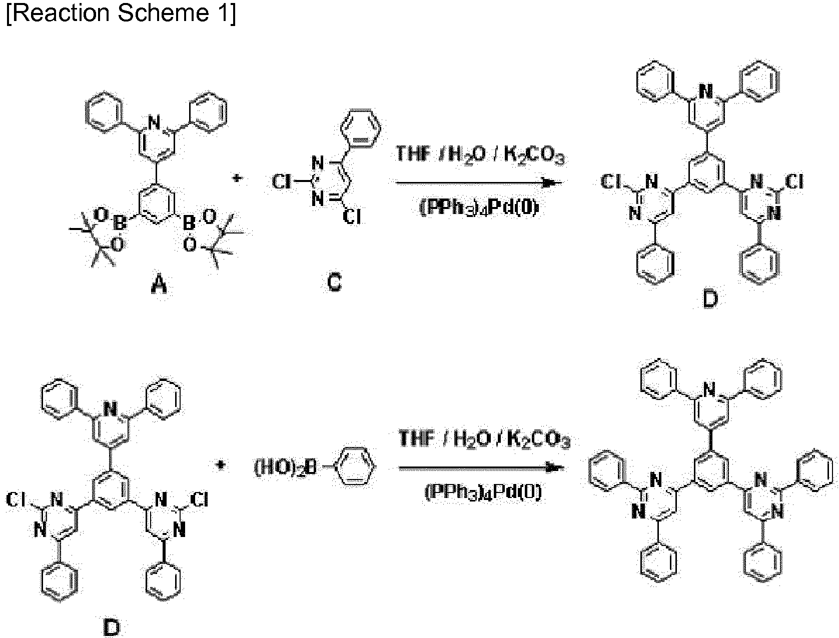

### First step: Synthesis of intermediate product (D)

In a mL round-bottomed flask having a thermometer, a reflux condenser, and an agitator, 8.0 g (14.3 mmol) of compound (A), 8.04 g (35.7 mmol) of compound (C), and 0.8 g (0.69 mmol) of tetrakis(triphenylphosphine)palladium were mixed with 300 mL of tetrahydrofuran under the nitrogen atmosphere, and then the mixed solution was mixed with 100 mL of 2 M potassium carbonate (K₂CO₃) and agitated at 70 ° C for 12 hours.

By cooling until a room temperature, the reaction of the reactant was completed, and then the produced solid was filtered and washed with methanol for several times. The final residue was purified by a silica-gel chromatography using a chloroform solvent to provide an intermediate product (D) in g (yield: 67.4 %).

### Second step: Synthesis of compound represented by Chemical Formula 3

In a mL round-bottomed flask having a thermometer, a reflux condenser, and an agitator, 6.6 g (9.64 mmol) of the intermediate product (D) synthesized in the second step, 4.42 g (24.1 mmol) of phenylboronic acid, and 0.7 g (0.6 mmol) of tetrakis(triphenylphosphine)palladium were mixed with 300 mL of tetrahydrofuran, and then the mixed solution was mixed with 100 mL of 2 M potassium carbonate (K₂CO₃) and agitated at 80 ° C for 12 hours to provide a white solid.

By cooling until a room temperature, the reaction of the reactant was completed, and then the potassium carbonate solution was removed to filter a white solid. The filtered white solid was washed with tetrahydrofuran for three times and washed with water for three times, and washed with methanol for three times and dried. The solid was dissolved in monochlorobenzene and agitated for 30 minutes with adding and active carbon, and the solution was filtered through a silica gel. The filtered monochlorobenzene was removed but remaining small amount to provide a white solid. The solid was filtered to provide a compound represented by Chemical Formula 3 in 5.8 g (yield: 78.3 %).

The obtained compound for an organic photoelectric device was analyzed by an atomic analyzer, and the results are as follows:
Calcd: C, 86.02; H, 4.86; N, 9.12
Found: C, 86.03; H, 4.85; N, 9.12

### Example 2: Synthesis of compound represented by Chemical Formula 7

As a further example of the present invention, the compound represented by Chemical Formula 7 was synthesized in accordance with the following Reaction Scheme 2.

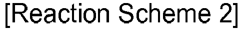

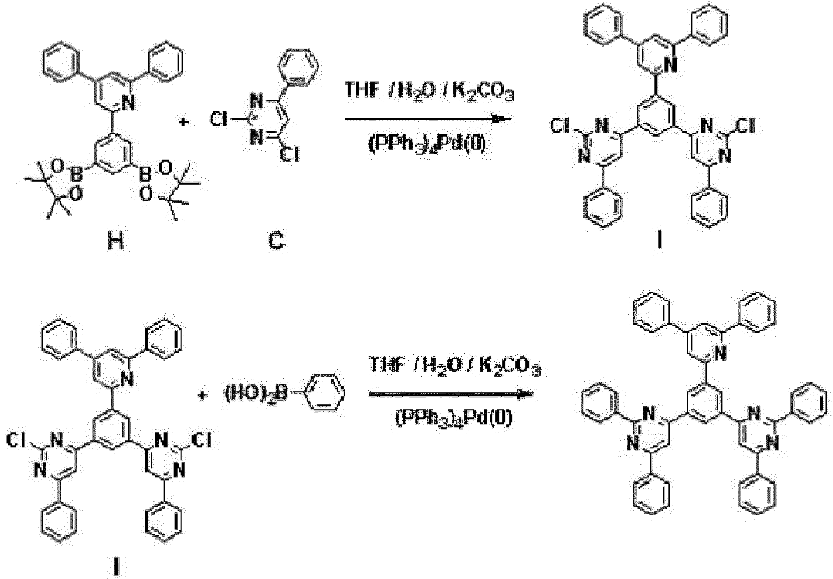

### First step: Synthesis of intermediate product (I)

In a mL round-bottomed flask having a thermometer, a reflux condenser, and an agitator, 8.0 g (14.3 mmol) of compound (H), 8.04 g (35.7 mmol) of compound (C), and 0.8 g (0.69 mmol) of tetrakis(triphenylphosphine)palladium were mixed with 300 mL tetrahydrofuran under the nitrogen atmosphere, and then the mixed solution was mixed with 100 mL of 2 M potassium carbonate (K₂CO₃) and agitated at 70 ° C for 12 hours.

By cooling to a room temperature, the reaction of the reactant was completed, and then the produced solid was filtered and washed with methanol for several times. The final residue was purified by a silica gel chromatography using a chloroform solvent to provide g (yield: 62.3 %) of an intermediate product (I).

### Second step: Synthesis of compound represented by Chemical Formula 7

In a mL round-bottomed flask having a thermometer, a reflux condenser, and an agitator, 6.1 g (8.91 mmol) of intermediate product (I), 4.3 g (23.4 mmol) of phenylboronic acid, and 0.7 g (0.6 mmol) of tetrakis(triphenylphosphine)palladium were mixed with 300 mL of tetrahydrofuran under the nitrogen atmosphere, and then the mixed solution was mixed with 100 mL of 2 M potassium carbonate (K₂CO₃) and agitated at 80 ° C for 12 hours to provide a white solid.

By cooling to a room temperature, the reaction of the reactant was completed, and the potassium carbonate solution was removed, and a white solid was filtered. The filtered white solid was washed with tetrahydrofuran for three times, washed with water for three times, and washed with methanol for three times, and dried. The solid was dissolved in monochlorobenzene and agitated for 30 minutes with adding an active carbon, and the solution was filtered through a silica-gel. The filtered monochlorobenzene was removed but remaining small amount to provide a white solid, and the solid was filtered to provide a compound represented by Chemical Formula 7 in 5.1 g (yield: 74.5 %).

The obtained compound for an organic photoelectric device was analyzed by an atomic analyzer, and the results are as follows:
Calcd: C, 86.02; H, 4.86; N, 9.12
Found: C, 86.06; H, 4.84; N, 9.10

### Example 3: Synthesis of compound represented by Chemical Formula 11

As a further example of the present invention, the compound represented by Chemical Formula 11 was synthesized in accordance with the following Reaction Scheme 3.

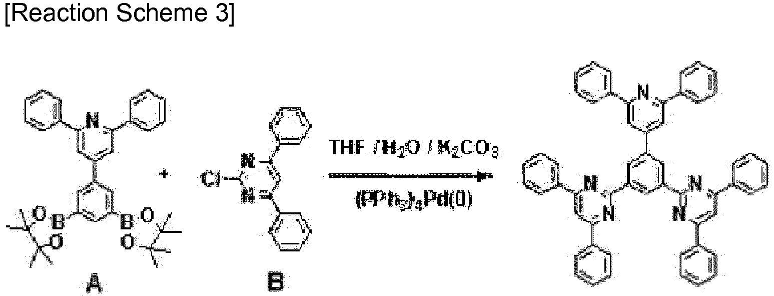

### First step: Synthesis of the compound represented by Chemical Formula 11

In a mL round-bottomed flask having a thermometer, a reflux condenser, and an agitator under the nitrogen atmosphere, 6.0 g (10.72 mmol) of compound (A), 6.58g (24.67 mmol) of compound (B), and 0.8 g (0.69 mmol) of tetrakis(triphenylphosphine)palladium were mixed with 300 mL of tetrahydrofuran, and then the mixed solution was mixed with 100 mL of 2 M potassium carbonate (K₂CO₃) and agitated at 80 ° C for 12 hours to provide a white solid.

By cooling to a room temperature, the reaction of the reactant was completed, and then the potassium carbonate solution was removed to filter the white solid. The filtered white solid was washed with tetrahydrofuran for three times, washed with water for three times, and washed with methanol for three times, and dried. The solid was dissolved in monochlorobenzene and agitated for 30 minutes with adding an active carbon, and the solution was filtered through a silica-gel. The filtered monochlorobenzene was removed but remaining small amount to provide a white solid, and the solid was filtered to provide a compound represented by Chemical Formula 11 in 7.1 g (yield: 86.2 %).

The obtained compound for an organic photoelectric device was analyzed by an atomic analyzer, and the results are as follows:
Calcd: C, 86.02; H, 4.86; N, 9.12
Found: C, 86.01; H, 4.87; N, 9.12

### Example 4: Synthesis of compound represented by Chemical Formula 14

As a further example of the present invention, the compound represented by Chemical Formula 14 was synthesized in accordance with the following Reaction Scheme 4.

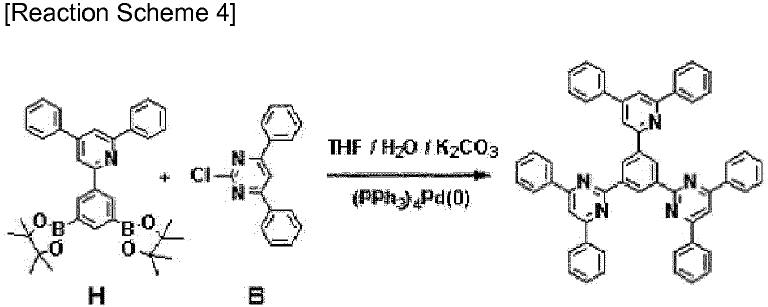

### First step: Synthesis of compound represented by Chemical Formula 14

In a mL round-bottomed flask having a thermometer, a reflux condenser, and an agitator, 6.0 g (10.72 mmol) of compound (H), 6.58g (24.67 mmol) of compound (B), and 0.8 g (0.69 mmol) of tetrakis(triphenylphosphine)palladium were mixed with 300 mL of tetrahydrofuran under the nitrogen atmosphere, and the mixed solution was mixed with 100 mL of 2 M potassium carbonate (K₂CO₃) and agitated at 80 ° C for 12 hours to provide a white solid.

By cooling to a room temperature, the reaction of the reactant was completed, and then the potassium carbonate was removed to filter the white solid. The filtered white solid was washed with tetrahydrofuran for three times, washed with water for three times, and washed with methanol for three times, and dried. The solid was dissolved in monochlorobenzene and agitated for 30 minutes with adding an active carbon, and the solution was filtered through a silica-gel. The filtered monochlorobenzene was removed but remaining small amount to provide a white solid, and the solid was filtered to provide a compound represented by Chemical Formula 14 in 6.9 g (yield: 83.8%).

The obtained compound for an organic photoelectric device was analyzed by an atomic analyzer, and the results are as follows:
Calcd: C, 86.02; H, 4.86; N, 9.12
Found: C, 86.03; H, 4.87; N, 9.10

### Example 5: Synthesis of compound represented by Chemical Formula 19

As a further example of the present invention, the compound represented by Chemical Formula 19 was synthesized in accordance with the following Reaction Scheme 5.

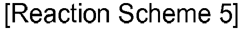

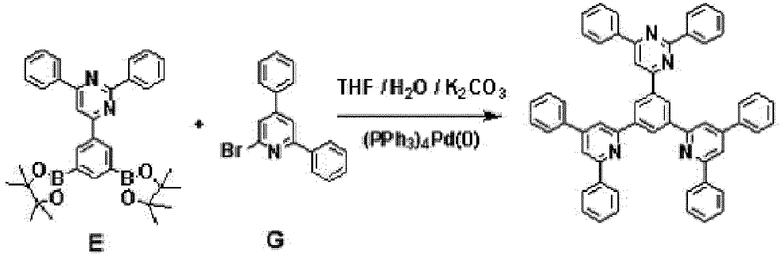

### First step: Synthesis of compound represented by Chemical Formula 19

In a mL round-bottomed flask having a thermometer, a reflux condenser, and an agitator, 6.0 g (10.7 mmol) of compound (E), 7.63g (24.6 mmol) of compound (G), and 0.8 g (0.69 mmol) of tetrakis(triphenylphosphine)palladium were mixed with 300 mL of tetrahydrofuran under the nitrogen atmosphere, and then the mixed solution was mixed with 100 mL of 2 M potassium carbonate (K₂CO₃) and agitated at 80 ° C for 12 hours to provide a white solid.

By cooling to a room temperature, the reaction of the reactant was completed, and then the potassium carbonate solution was removed to provide the white solid. The provided white solid was washed with tetrahydrofuran for three times, washed with water for three times, and washed with methanol for three times, and dried. The solid was dissolved in monochlorobenzene and agitated for 30 minutes with adding an active carbon, and the solution was filtered through a silica-gel. The filtered monochlorobenzene was removed but remaining small amount to provide a white solid, and the solid was filtered to provide a compound represented by Chemical Formula 19 in 7.3 g (yield: 88.9 %).

The obtained compound for an organic photoelectric device was analyzed by an atomic analyzer, and the results are as follows:
Calcd: C, 87.70; H, 4.99; N, 7.31
Found: C, 87.72; H, 4.97; N, 7.31

### Example 6: Synthesis of compound represented by Chemical Formula 21

As a further example of the present invention, the compound represented by Chemical Formula 21 was synthesized in accordance with the following Reaction Scheme 6.

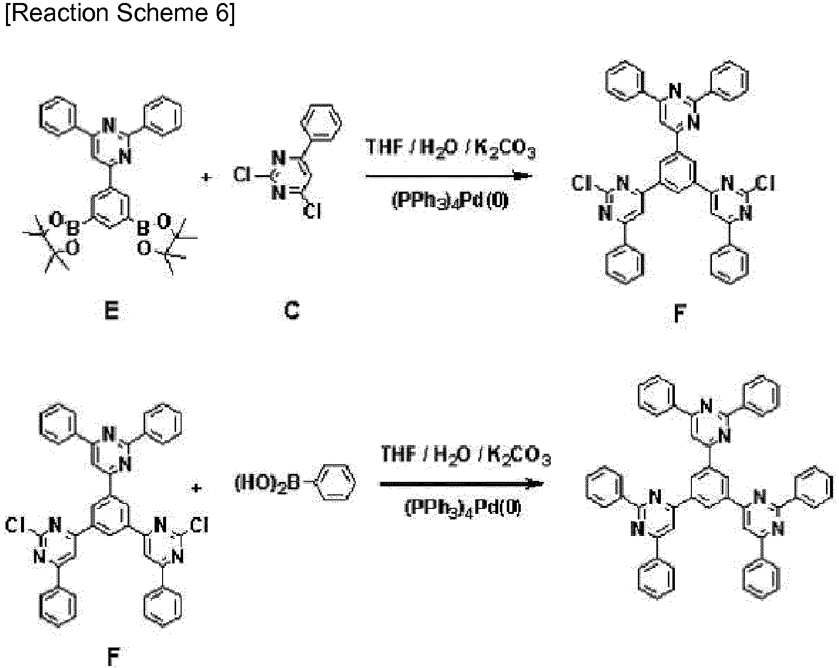

### First step: Synthesis of intermediate product (F)

In a mL round-bottomed flask having a thermometer, a reflux condenser, and an agitator, 8.0 g (14.2 mmol) of compound (E), 8.03 g (35.6 mmol) of compound (C), and 0.8 g (0.69 mmol) of tetrakis(triphenylphosphine)palladium were mixed with 300 mL of tetrahydrofuran under the nitrogen atmosphere, and then the mixed solution was mixed with 100 mL of 2 M potassium carbonate (K₂CO₃) and agitated at 70 ° C for 12 hours.

By cooling to a room temperature, the reaction of the reactant was completed, and then the produced solid was filtered and washed with methanol for several times. The final residue was purified by a silica-gel chromatography using a chloroform solvent to provide an intermediate product (F) in g (yield: 69.8 %).

### Second step: Synthesis of compound represented by Chemical Formula 21

In a mL round-bottomed flask having a thermometer, a reflux condenser, and an agitator, 6.8 g (9.91 mmol) of intermediate product (F) synthesized in the second step, 4.54 g (24.7 mmol) of phenylboronic acid, and 0.7 g (0.6 mmol) of tetrakis(triphenylphosphine)palladium were mixed with 300 mL of tetrahydrofuran under the nitrogen atmosphere, and the mixed solution was mixed with 100 mL of 2 M potassium carbonate (K₂CO₃) and agitated at 80 ° C for 12 hours to provide a white solid.

By cooling to a room temperature, the reaction of the reactant was completed, and the potassium carbonate solution was removed to provide a white solid. The provided white solid was washed with tetrahydrofuran for three times, washed with water for three times, and washed with methanol for three times, and dried. The solid was dissolved in monochlorobenzene and agitated for 30 minutes with adding an active carbon, and the solution was filtered through a silica-gel. The filtered monochlorobenzene was removed but remaining small amount to provide a white solid, and the solid was filtered to provide a compound represented by Chemical Formula 21 in 5.3 g (yield: 69.5 %).

The obtained compound for an organic photoelectric device was analyzed by an atomic analyzer, and the results are as follows:
Calcd: C, 84.35; H, 4.72; N, 10.93
Found: C, 84.37; H, 4.70; N, 10.93

The synthesized materials were measured for a glass transition temperature and a thermal decomposition temperature by DSC and TGA.

### (Fabrication of organic photoelectric device)

### Example 7

An ITO glass (120 nm) substrate having sheet resistance of 15Ω/cm² was cut to a size of 50mm x 50mm x 0.7mm and ultrasonic wave cleaning the same in isopropylalcohol and pure water for for 5 minutes each, and UV ozone cleaning the same for 30 minutes to provide an anode.

DNTPD (40nm), N,N'-di(1naphthyl)N,N'diphenylbenzidine (NPB, 10nm), and EB46:EB512 4% (40nm) was sequentially thermally vacuum-deposited to form a hole injection layer (HIL), a hole transport layer, and an emission layer, sequentially.

By adjusting the deposition speed of the dopant, the dopant was deposited in a mixture amount of 4 wt% based on total amount of 100 wt% of the emission layer.

According to the same thermal vacuum deposition condition, an electron transport layer (ETL) was provided on the upper part of the emission layer in a thickness of 30 nm using the compound synthesized from Example 1 and LiQ (weight ratio of 1: 1).

According to the same thermal vacuum deposition condition, LiQ (0.5 nm) and Al (100 nm) were sequentially deposited as a negative electrode on the upper part of the electron transport layer (ETL) to provide an organic light emitting diode.

### Comparative Example 1

An organic light emitting diode was fabricated in accordance with the same procedure as in Example 7, except that the compound represented by Chemical Formula 34 and LiQ (weight ratio of 1:1) were used to provide an electron transport layer (ETL) instead of using the compound synthesized from Example 1 and LiQ (weight ratio of 1: 1).

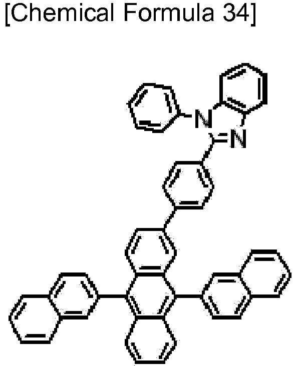

### Measurement of performance of organic photoelectric device

### Experimental Examples

### Measurement method

Each of the obtained organic photoelectric devices was measured for luminance change, current density change depending upon the voltage, and luminous efficiency. The specific method was as follows.
1) Measurement of current density change depending on voltage change
   The obtained organic photoelectric device was measured for current value flowing in the unit device while increasing the voltage from 0V to 14V using a current-voltage meter (Keithley 2400), and the measured current value was divided by area to provide the result.
2) Measurement of luminance change depending on voltage change
   The obtained organic photoelectric device was measured for luminance using a luminance meter (Minolta Cs1000A) while increasing the voltage.
3) Measurement of luminous efficiency
   Current efficiency (cd/A) and electric power efficiency (lm/W) at the same luminance (1000cd/m²) were calculated by using luminance and current density from 1) and 2) and voltage. The results are shown in the following Table 1.
4) Color coordinate was measured a luminance meter (Minolta Cs100A), and the results are shown in the following Table 1.

### Results

### Table

Table 1 shows results of the organic photoelectric devices according to Example 7 and Comparative Example 1.

**(Table 1)**

| | Measurement at 1000 cd/m² | | | |
|---|---|---|---|---|
| Devices | Driving | Current | Electric power | Color coordinate |
| | voltage | efficiency | efficiency | (x, y) |
| | (V) | (cd/A) | (lm/W) | |
| Example 7 | 3.8 | 10.81 | 8.94 | 0.15,0.19 |
| Comparative Example 1 | 4.4 | 7.65 | 5.46 | 0.15,0.20 |

Referring to Table 1, the results of evaluating characteristics of organic light emitting diode show that the organic light emitting diode obtained from Example 7 had lower driving voltage than the organic light emitting diode of Comparative Example 1 and the device performance in which the current efficiency and the electric power efficiency were highly improved. It is confirmed that the compound synthesized from Examples decreased the driving voltage of organic light emitting diode and improved the luminance and the efficiency.

From the results, organic photoelectric devices including the compounds according to embodiments show a low driving voltage and high luminous efficiency and thus an increased life span of a device.

While this invention has been described in connection with what is presently considered to be practical exemplary embodiments, it is to be understood that the invention is not limited to the disclosed embodiments. Therefore, the aforementioned embodiments should be understood to be exemplary but not limiting the present invention in any way.

## Claims

1. A compound for an organic photoelectric device represented by the following Chemical Formula 1 or 2: 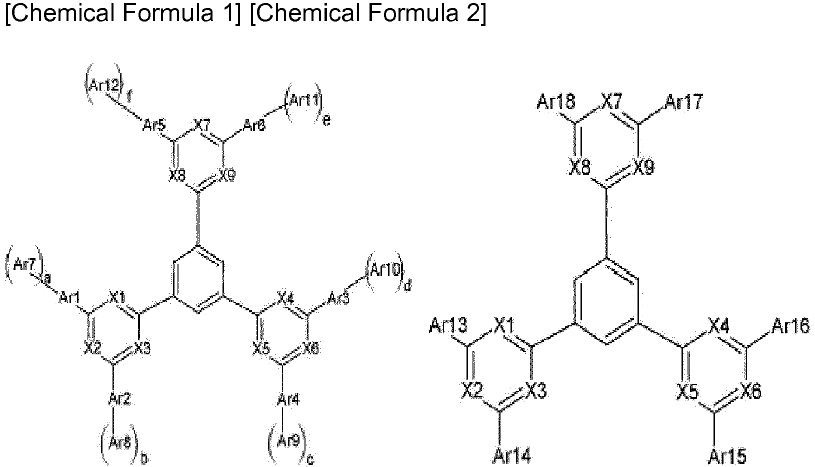 wherein, in Chemical Formulae 1 and 2,
X1 to X9 are the same or different and independently N or CR, wherein R is selected from the group consisting of hydrogen, a C1 to C30 alkyl group, and a C6 to C30 aryl group,
at least two of X1 to X3 are N, at least one of X4 to X6 is N, and at least one of X7 to X9 is N,
whrerein, in Chemical Formula 1,
Ar1 to Ar6 are the same or different and are independently selected from the group consisting of a substituted or unsubstituted C6 to C30 arylene group, a substituted or unsubstituted C3 to C30 heteroarylene group, a substituted or unsubstituted C6 to C30 arylaminylene group, a substituted or unsubstituted carbazolylene group, and a substituted or unsubstituted fluorenylene group,
Ar7 to Ar12 are the same or different and are independently selected from the group consisting of a substituted or unsubstituted C6 to C30 aryl group or a substituted or unsubstituted C3 to C30 heteroaryl group, and
a, b, c, d, e, and f are the same or different and are independently an integer ranging from 1 to 2,
wherein in Chemical Formula 2,
Ar13 to Ar18 are the same or different and are independently selected from the group consisting of a substituted or unsubstituted C6 to C30 aryl group, a substituted or unsubstituted C3 to C30 heteroaryl group, a substituted or unsubstituted C6 to C30 arylamine group, a substituted or unsubstituted carbazolyl group, and a substituted or unsubstituted fluorenyl group.

2. The compound for an organic photoelectric device of claim 1, wherein at least two of X4 to X6 are N.

3. The compound for an organic photoelectric device of claim 1,
wherein the compound for an organic photoelectric device represented by the above Chemical Formula 1 or 2 is
a compound where X2, X3, X5, X6, and X7 are N or,
a compound where X2, X3, X5, X6, and X9 are N.

4. The compound for an organic photoelectric device of claim 1,
wherein the compound for an organic photoelectric device represented by the above Chemical Formula 1 or 2 is selected from the group consisting of
a compound where X2, X3, X5, X6, X7, and X9 are N;
a compound where X2, X3, X5, X6, X8, and X9 are N;
a compound where X1, X3, X4, X5, X8, and X9 are N; and
a compound where X1, X3, X4, X5, X7, and X9 are N.

5. The compound for an organic photoelectric device of claim 1, wherein the compound for an organic photoelectric device represented by the above Chemical Formula 1 or 2 is
a compound where X2, X6, X7, and X9 are N or
a compound where X3, X5, X7, and X9 are N.

6. The compound for an organic photoelectric device of claim 1,
wherein the compound for an organic photoelectric device represented by the above Chemical Formula 1 or 2 is
a compound where X2, X6, X7, X8, and X9 are N or
a compound where X3, X5, X7, X8, and X9 are N.

7. The compound for an organic photoelectric device of claim 1,
wherein the compound for an organic photoelectric device represented by the above Chemical Formula 1 or 2 is
a compound where X2, X3, X5, X6, X7, X8, and X9 are N, or
a compound where X1, X3, X4, X5, X7, X8, and X9 are N.

8. The compound for an organic photoelectric device of claim 1,
wherein in Chemical Formula 1,
Ar7 to Ar12 are the same or different and are independently selected from the group consisting of a phenyl group, a biphenyl group, a terphenyl group, a stilbenyl group, a naphthyl group, an anthracenyl group, a phenanthrenyl group, a pyrenyl group, and a perylenyl group, and
Ar1 to Ar6 are the same or different and are independently selected from the group consisting of a phenylene group, a biphenylene group, a terphenylene group, a stilbenylene group, naphthylene group, an anthracenylene group, a phenanthrenylene group, a pyrenylene group, and a perylenylene group, and
in Chemcial Formula 2,
Ar13 to Ar18 are the same or different and are independently selected from the group consisting of a phenyl group, a biphenyl group, a terphenyl group, a stilbenyl group, a naphthyl group, an anthracenyl group, a phenanthrenyl group, a pyrenyl group, and a perylenyl group.

9. The compound for an organic photoelectric device of claim 1,
wherein in Chemical Formula 1,
Ar7 to Ar12 are the same or different and are independently selected from the group consisting of a thiophenyl group, a furanyl group, a pyrrolyl group, an imidazolyl group, a thiazolyl group, an oxazolyl group, an oxadiazolyl group, a triazolyl group, a pyridinyl group, a pyridazinyl group, a quinolinyl group, an isoquinolinyl group, an acridinyl group, an imidazopyridinyl group, an imidazopyrimidinyl group, a benzoquinolinyl group, and a phenanthrolinyl group, and
in Chemical Formula 2,
Ar13 to Ar18 are the same or different and are independently selected from the group consisting of a thiophenyl group, a furanyl group, a pyrrolyl group, an imidazolyl group, a thiazolyl group, an oxazolyl group, an oxadiazolyl group, a triazolyl group, a pyridinyl group, a pyridazinyl group, a quinolinyl group, an isoquinolinyl group, an acridinyl group, an imidazopyridinyl group, an imidazopyrimidinyl group, a benzoquinolinyl group, and a phenanthrolinyl group.

10. A compound for an organic photoelectric device represented by one of the following Chemical Formulae 3 to 33:

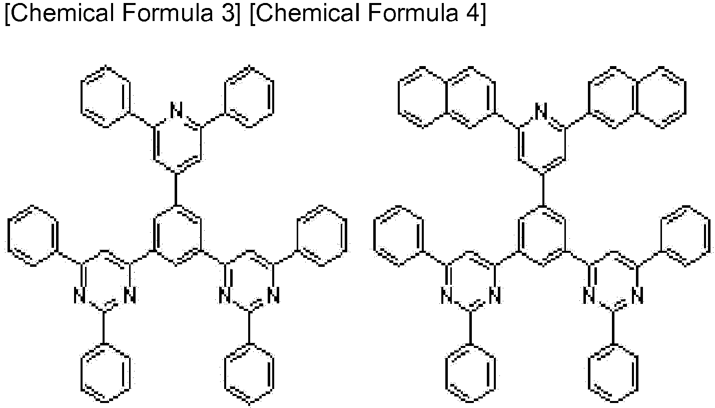

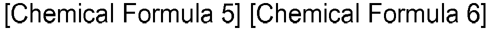

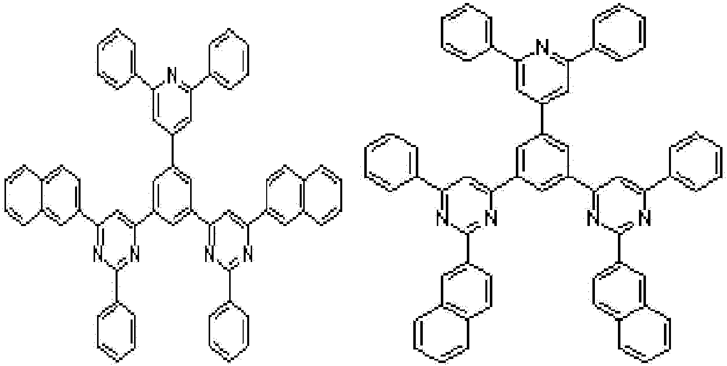

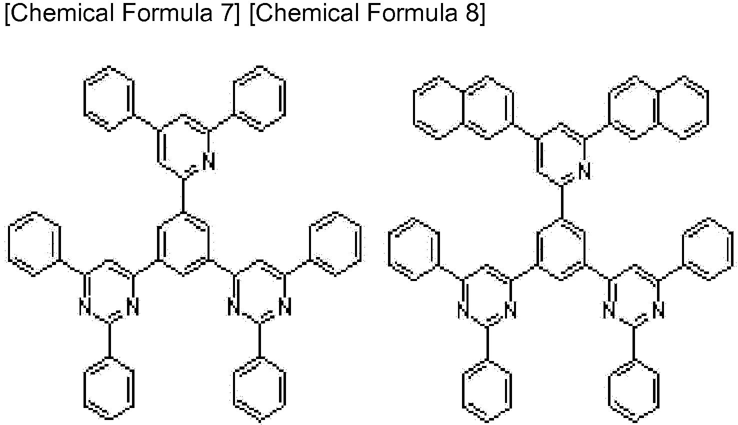

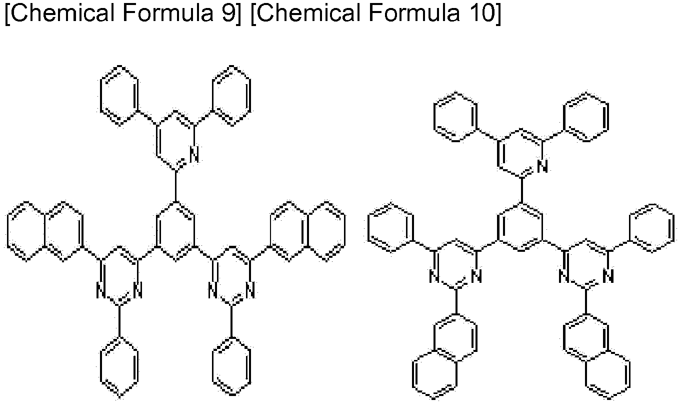

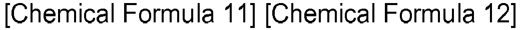

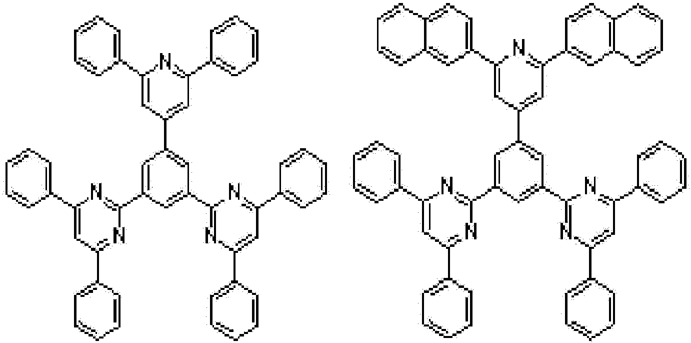

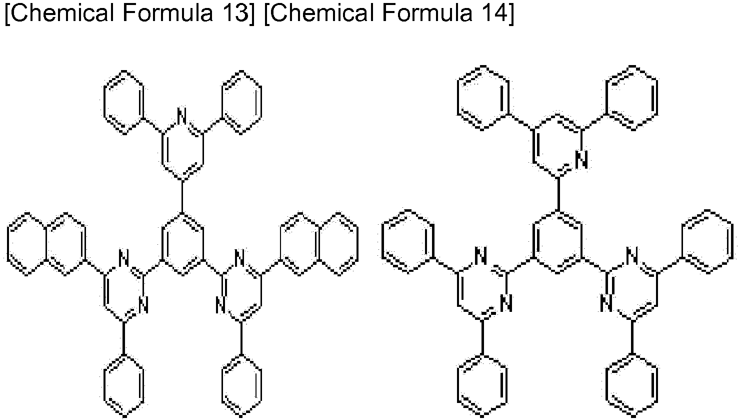

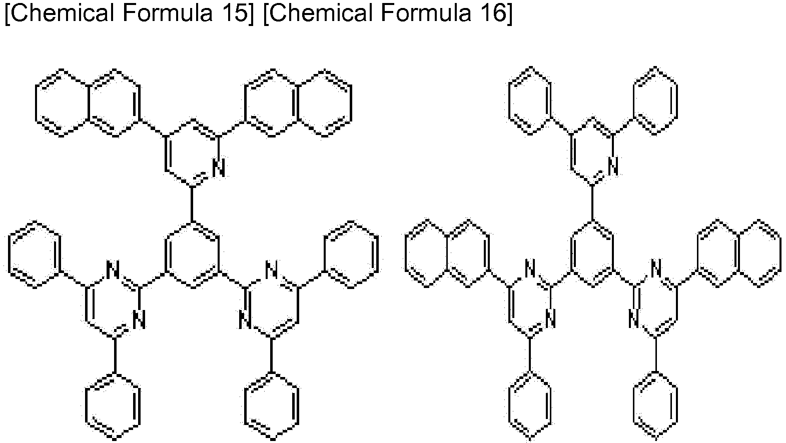

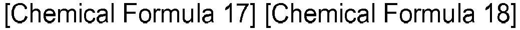

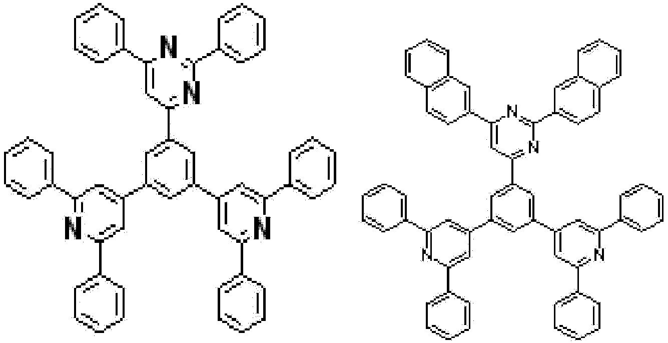

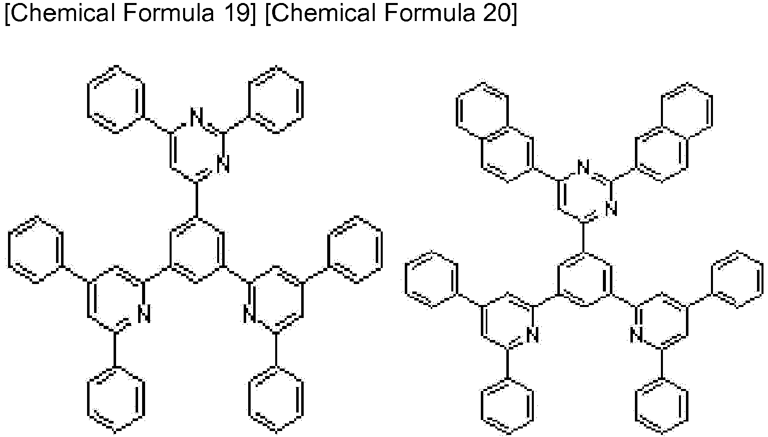

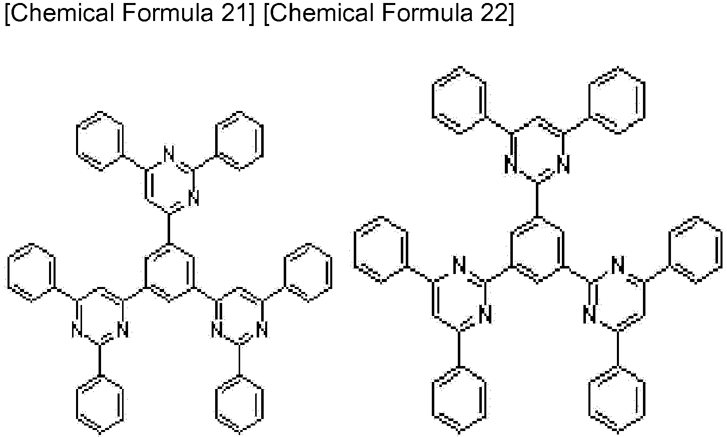

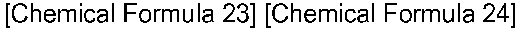

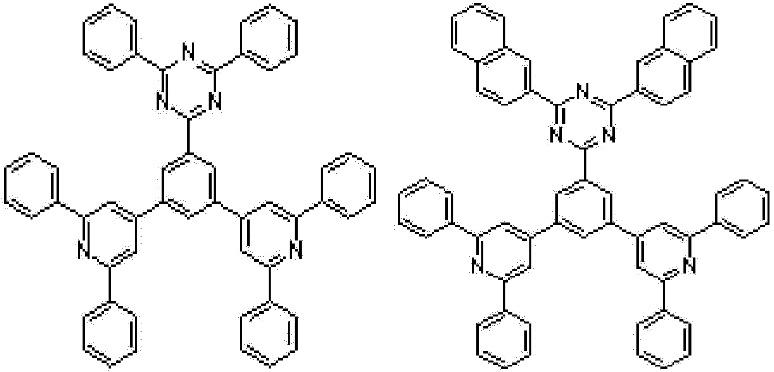

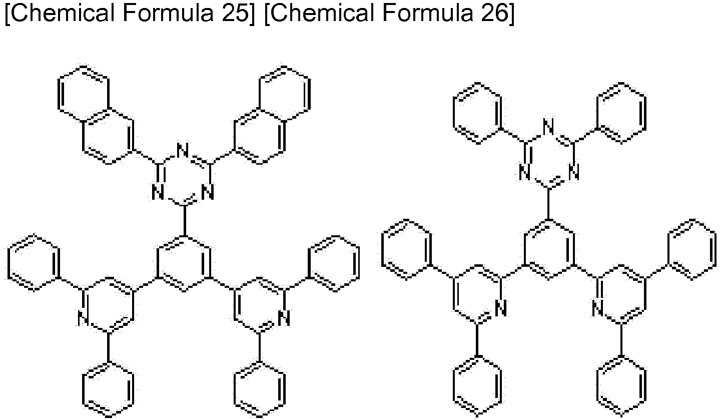

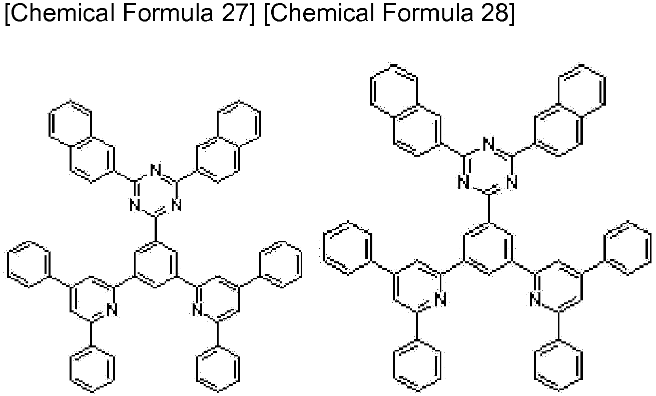

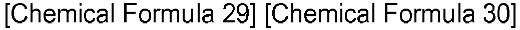

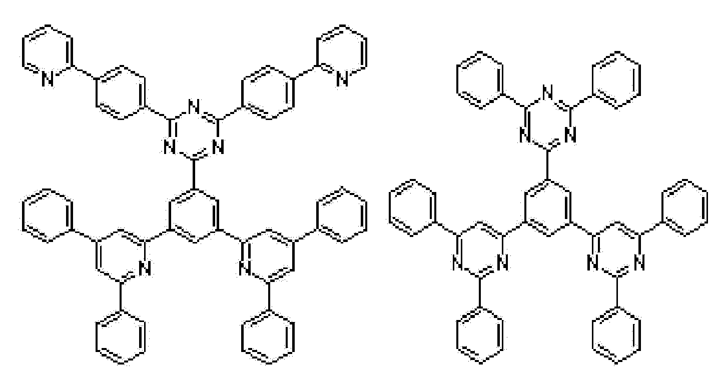

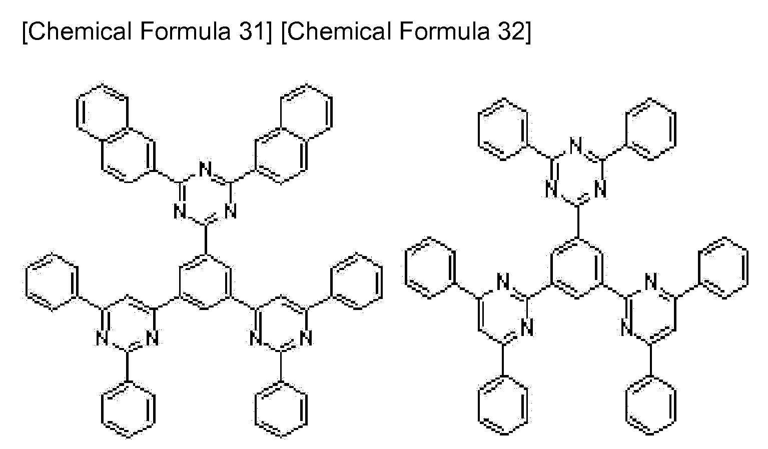

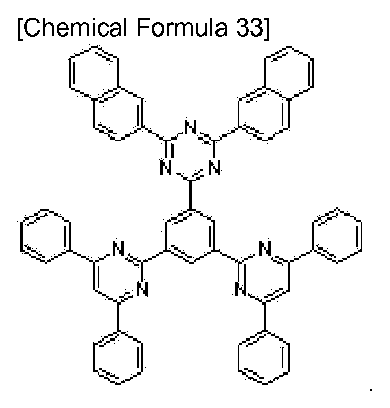

11. An organic photoelectric device comprising
an anode, a cathode, and at least one or more organic thin layers between the anode and the cathode,
wherein at least one of the organic thin layer comprises the compound for an organic photoelectric device according to one of claims 1 to 10.

12. The organic photoelectric device of claim 11, wherein the organic thin layer is selected from the group consisting of an emission layer, a hole transport layer (HTL), a hole injection layer (HIL), an electron transport layer (ETL), an electron injection layer (EIL), a hole blocking layer, and a combination thereof.

13. The organic photoelectric device of claim 11, wherein the compound for an organic photoelectric device is included in an electron transport layer (ETL) or an electron injection layer (EIL).

14. The organic photoelectric device of claim 11, wherein the compound for an organic photoelectric device is included in an emission layer.

15. The organic photoelectric device of claim 11, wherein the compound for an organic photoelectric device is used as a phosphorescent or fluorescent host material in an emission layer.

16. The organic photoelectric device of claim 11, wherein the compound for an organic photoelectric device is used as a fluorescent blue dopant material in an emission layer.

17. The organic photoelectric device of claim 11, wherein the organic photoelectric device is selected from the group consisting of an organic light emitting diode, an organic solar cell, an organic transistor, an organic photo conductor drum, and an organic memory device.

18. A display device including the organic photoelectric device according to claim 11.

## Patentansprüche

1. Verbindung für eine organische fotoelektrische Vorrichtung, dargestellt durch die folgenden chemischen Formeln 1 oder 2: 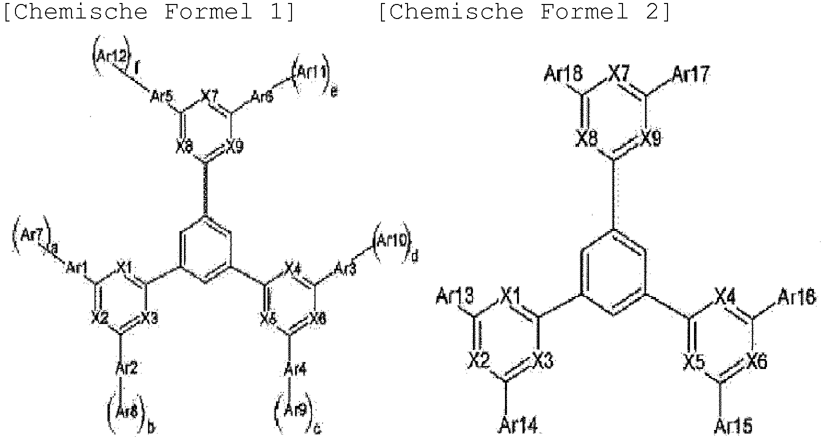 wobei in den chemischen Formeln 1 und 2
X1 bis X9 gleich oder verschieden und unabhängig N oder CR sind, wobei R ausgewählt ist aus der Gruppe bestehend aus Wasserstoff, einer C1- bis C30-Alkylgruppe und einer C6-C30-Arylgruppe,
mindestens zwei von X1 bis X3 N sind, mindestens eins von X4 bis X6 N ist und mindestens eins von X7 bis X9 N ist,
wobei in der chemischen Formel 1
Ar1 bis Ar6 gleich oder verschieden sind und unabhängig ausgewählt sind aus der Gruppe bestehend aus einer substituierten oder unsubstituierten C6- bis C30-Arylengruppe, einer substituierten oder unsubstituierten C3- bis C30-Heteroarylengruppe, einer substituierten oder unsubstituierten C6- bis C30-Arylaminylengruppe, einer substituierten oder unsubstituierten Carbazolylengruppe und einer substituierten oder unsubstituierten Fluorenylengruppe,
Ar7 bis Ar12 gleich oder verschieden sind und unabhängig ausgewählt sind aus der Gruppe bestehend aus einer substituierten oder unsubstituierten C6- bis C30-Arylgruppe oder einer substituierten oder unsubstituierten C3- bis C30-Heteroarylgruppe, und
a, b, c, d, e und f gleich oder verschieden sind und unabhängig eine ganze Zahl sind im Bereich von 1 bis 2,
wobei in der chemischen Formel 2,
Ar13 bis Ar18 gleich oder verschieden sind und unabhängig ausgewählt sind aus der Gruppe bestehend aus einer substituierten oder unsubstituierten C6- bis C30-Arylgruppe, einer substituierten oder unsubstituierten C3- bis C30-Heteroarylgruppe, einer substituierten oder unsubstituierten C6- bis C30-Arylamingruppe, einer substituierten oder unsubstituierten Carbazolylgruppe und einer substituierten oder unsubstituierten Fluorenylgruppe.

2. Verbindung für eine organische fotoelektrische Vorrichtung nach Anspruch 1, wobei mindestens zwei von X4 bis X6 N sind.

3. Verbindung für eine organische fotoelektrische Vorrichtung nach Anspruch 1,
wobei die Verbindung für eine organische fotoelektrische Vorrichtung, durch die obige chemische Formel 1 oder 2 dargestellt,
eine Verbindung, in der X2, X3, X5, X6 und X7 N sind, oder
eine Verbindung, in der X2, X3, X5, X6 und X9 N sind, ist.

4. Verbindung für eine organische fotoelektrische Vorrichtung nach Anspruch 1, wobei die Verbindung für eine organische fotoelektrische Vorrichtung, durch die obige chemische Formel 1 oder 2 dargestellt, ausgewählt ist aus der Gruppe bestehend aus
einer Verbindung, in der X2, X3, X5, X6, X7 und X9 N sind;
einer Verbindung, in der X2, X3, X5, X6, X8 und X9 N sind;
einer Verbindung, in der X1, X3, X4, X5, X8 und X9 N sind; und
einer Verbindung, in der X1, X3, X4, X5, X7 und X9 N sind.

5. Verbindung für eine organische fotoelektrische Vorrichtung nach Anspruch 1, wobei die Verbindung für eine organische fotoelektrische Vorrichtung, durch die obige chemische Formel 1 oder 2 dargestellt,
eine Verbindung, in der X2, X6, X7 und X9 N sind, oder
eine Verbindung, in der X3, X5, X7 und X9 N sind, ist.

6. Verbindung für eine organische fotoelektrische Vorrichtung nach Anspruch 1,
wobei die Verbindung für eine organische fotoelektrische Vorrichtung, durch die obige chemische Formel 1 oder 2 dargestellt,
eine Verbindung, in der X2, X6, X7, X8 und X9 N sind, oder
eine Verbindung, in der X3, X5, X7, X8 und X9 N sind, ist.

7. Verbindung für eine organische fotoelektrische Vorrichtung nach Anspruch 1,
wobei die Verbindung für eine organische fotoelektrische Vorrichtung, durch die obige chemische Formel 1 oder 2 dargestellt,
eine Verbindung, in der X2, X3, X5, X6, X7, X8 und X9 N sind, oder
eine Verbindung, in der X1, X3, X4, X5, X7, X8 und X9 N sind, ist.

8. Verbindung für eine organische fotoelektrische Vorrichtung nach Anspruch 1,
wobei in der chemischen Formel 1
Ar7 bis Ar12 gleich oder verschieden sind und unabhängig ausgewählt sind aus der Gruppe bestehend aus einer Phenylgruppe, einer Biphenylgruppe, einer Terphenylgruppe, einer Stilbenylgruppe, einer Naphthylgruppe, einer Anthracenylgruppe, einer Phenanthrenylgruppe, einer Pyrenylgruppe und einer Perylenylgruppe, und
Ar1 bis Ar6 gleich oder verschieden sind und unabhängig ausgewählt sind aus der Gruppe bestehend aus einer Phenylengruppe, einer Biphenylengruppe, einer Terphenylengruppe, einer Stilbenylengruppe, einer Naphthylengruppe, einer Anthracenylengruppe, einer Phenanthrenylengruppe, einer Pyrenylengruppe und einer Perylenylengruppe, und
in der chemischen Formel 2
Ar13 bis Ar18 gleich oder verschieden sind und unabhängig ausgewählt sind aus der Gruppe bestehend aus einer Phenylgruppe, einer Biphenylgruppe, einer Terphenylgruppe, einer Stilbenylgruppe, einer Naphthylgruppe, einer Anthracenylgruppe, einer Phenanthrenylgruppe, einer Pyrenylgruppe und einer Perylenylgruppe.

9. Verbindung für eine organische fotoelektrische Vorrichtung nach Anspruch 1,
wobei in der chemischen Formel 1
Ar7 bis Ar12 gleich oder verschieden sind und unabhängig ausgewählt sind aus der Gruppe bestehend aus einer Thiophenylgruppe, einer Furanylgruppe, einer Pyrrolylgruppe, einer Imidazolylgruppe, einer Thiazolylgruppe, einer Oxazolylgruppe, einer Oxadiazolylgruppe, einer Triazolylgruppe, einer Pyridinylgruppe, einer Pyridazinylgruppe, einer Chinolinylgruppe, einer Isochinolinylgruppe, einer Acridinylgruppe, einer Imidazopyridinylgruppe, einer Imidazopyrimidinylgruppe, einer Benzochinolinylgruppe und einer Phenanthrolinylgruppe, und
in der chemischen Formel 2
Ar13 bis Ar18 gleich oder verschieden sind und unabhängig ausgewählt sind aus der Gruppe bestehend aus einer Thiophenylgruppe, einer Furanylgruppe, einer Pyrrolylgruppe, einer Imidazolylgruppe, einer Thiazolylgruppe, einer Oxazolylgruppe, einer Oxadiazolylgruppe, einer Triazolylgruppe, einer Pyridinylgruppe, einer Pyridazinylgruppe, einer Chinolinylgruppe, einer Isochinolinylgruppe, einer Acridinylgruppe, einer Imidazopyridinylgruppe, einer Imidazopyrimidinylgruppe, einer Benzochinolinylgruppe und einer Phenanthrolinylgruppe.

10. Verbindung für eine organische fotoelektrische Vorrichtung, dargestellt durch eine der folgenden chemischen Formeln 3 bis 33:

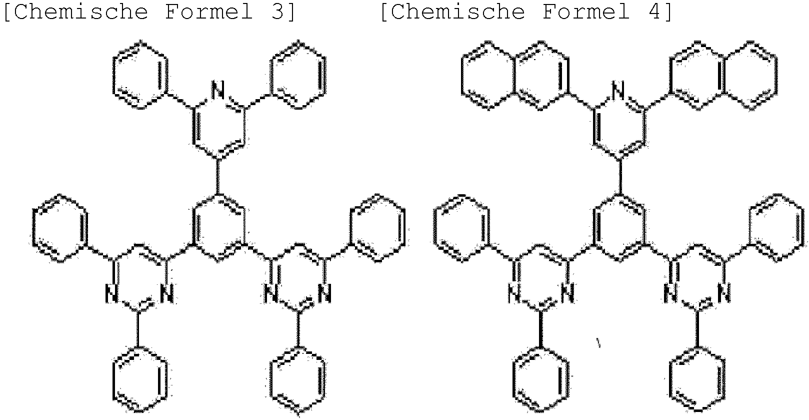

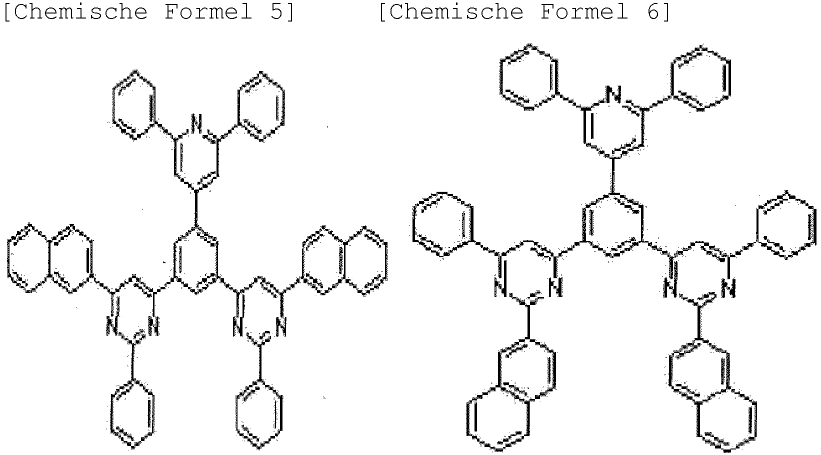

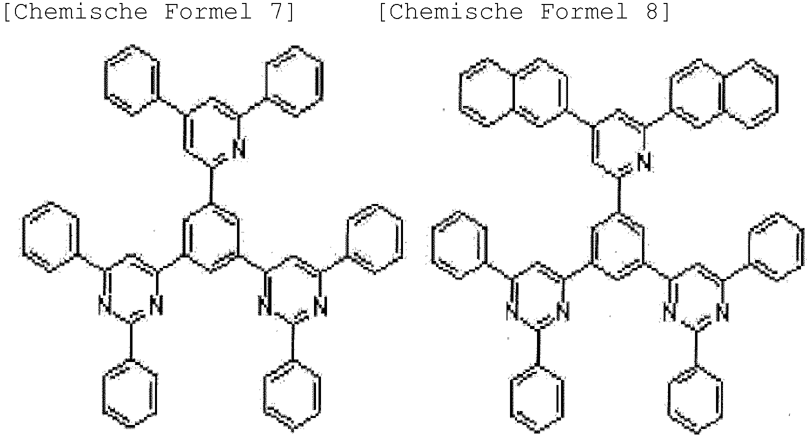

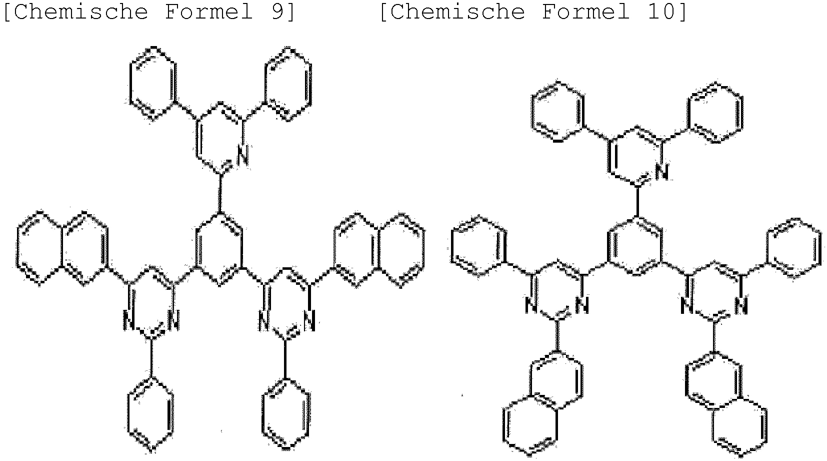

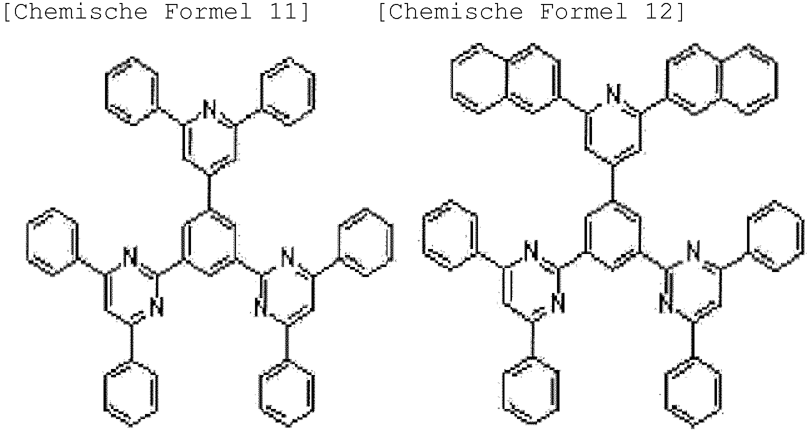

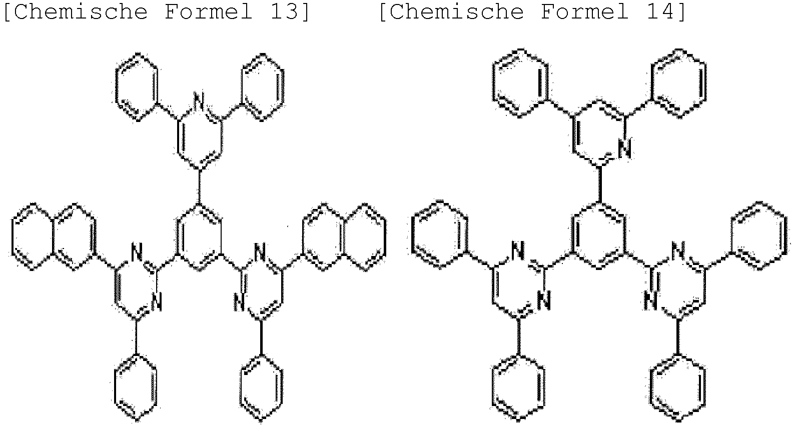

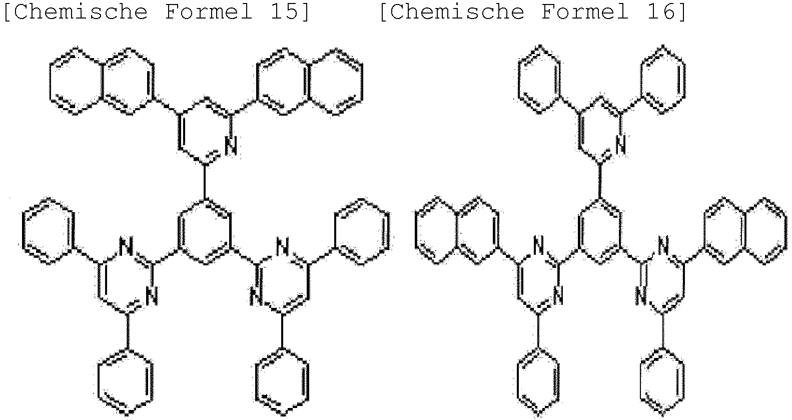

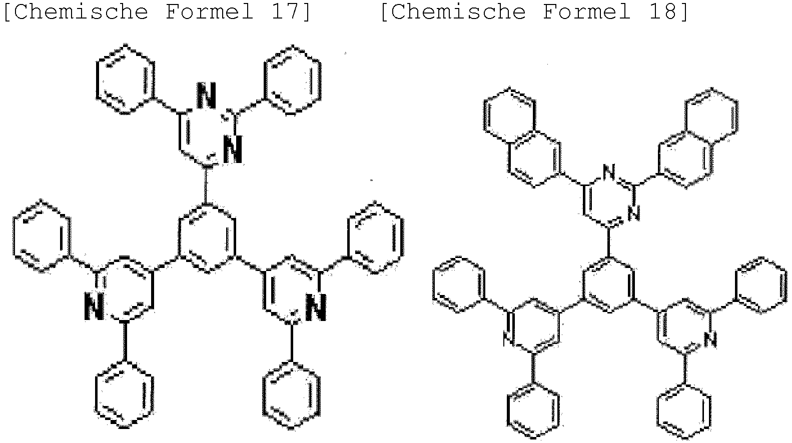

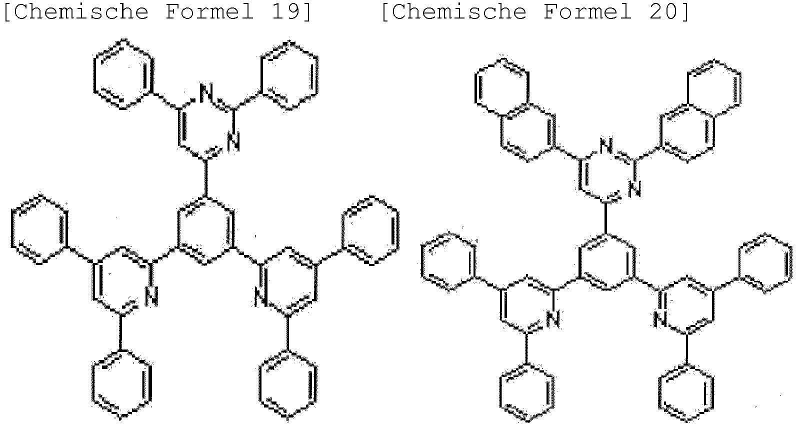

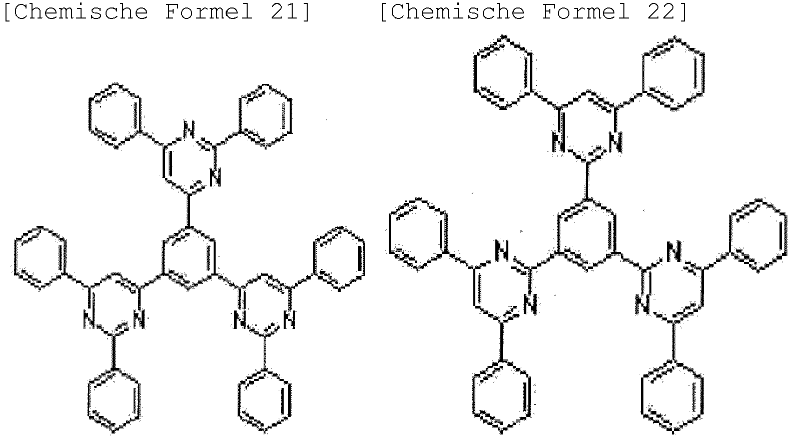

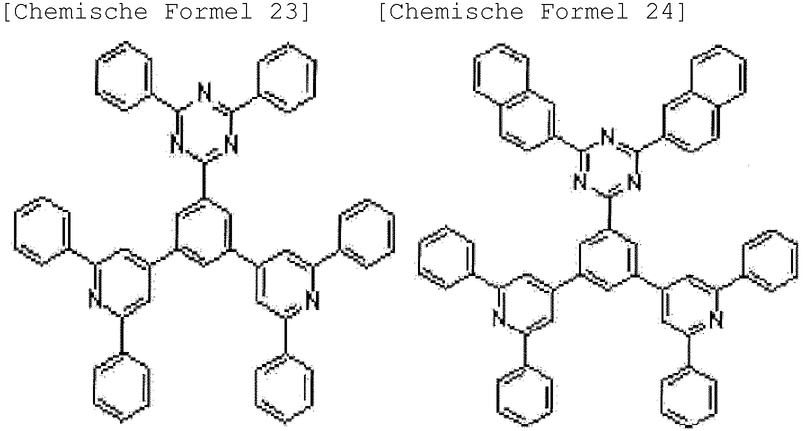

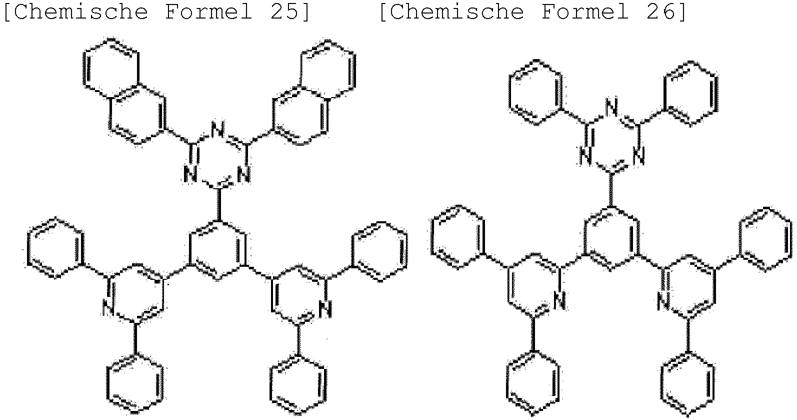

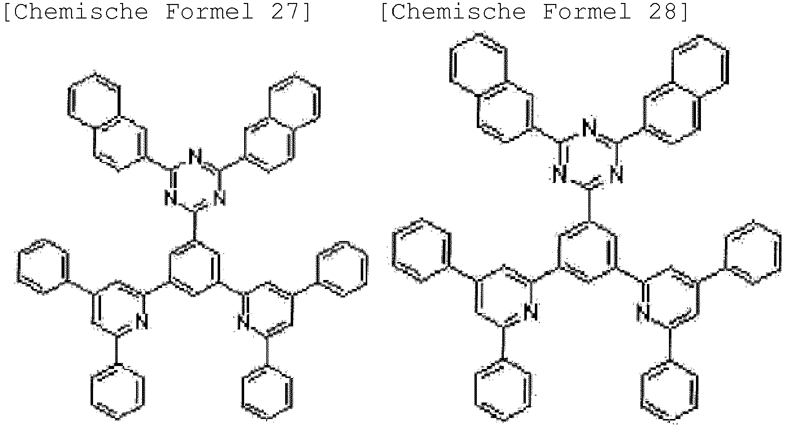

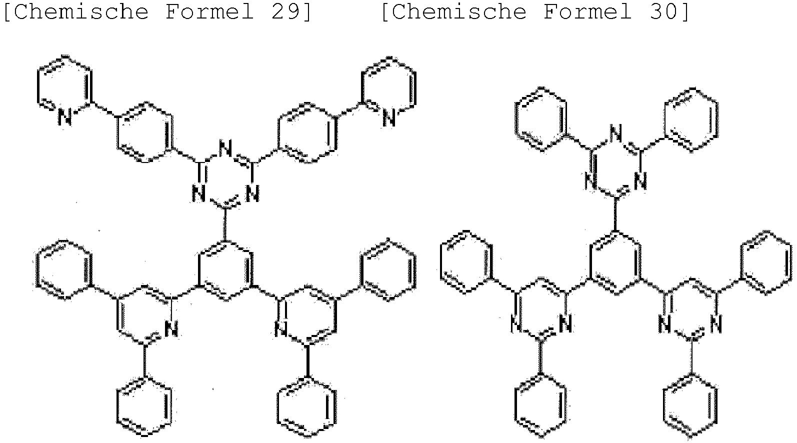

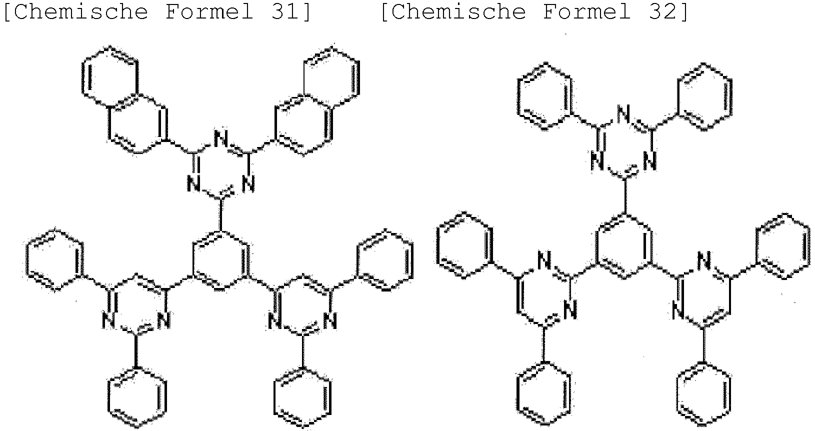

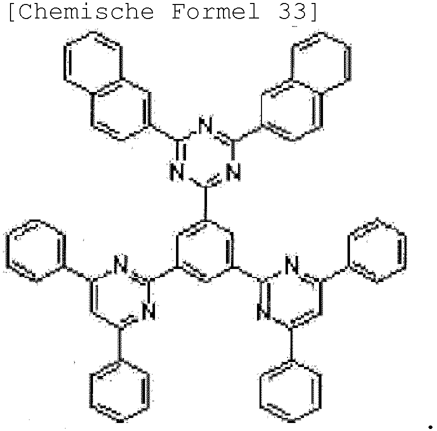

11. Organische fotoelektrische Vorrichtung, umfassend:
eine Anode, eine Kathode und mindestens eine oder mehrere organische Dünnschichten zwischen der Anode und der Kathode,
wobei mindestens eine der organischen Dünnschichten die Verbindung für eine organische fotoelektrische Vorrichtung nach einem der Ansprüche 1 bis 10 umfasst.

12. Organische fotoelektrische Vorrichtung nach Anspruch 11, wobei die organische Dünnschicht ausgewählt ist aus der Gruppe bestehend aus einer Emissionsschicht, einer Lochtransportschicht (HTL - Hole Transport Layer), einer Lochinjektionsschicht (HIL - Hole Injection Layer), einer Elektronentransportschicht (ETL - Electron Transport Layer), einer Elektroneninjektionsschicht (EIL - Electron Injection Layer), einer Lochblockierschicht und einer Kombination davon.

13. Organische fotoelektrische Vorrichtung nach Anspruch 11, wobei die Verbindung für eine organische fotoelektrische Vorrichtung in einer Elektronentransportschicht (ETL) oder einer Elektroneninjektionsschicht (EIL) enthalten ist.

14. Organische fotoelektrische Vorrichtung nach Anspruch 11, wobei die Verbindung für eine organische fotoelektrische Vorrichtung in einer Emissionsschicht enthalten ist.

15. Organische fotoelektrische Vorrichtung nach Anspruch 11, wobei die Verbindung für eine organische fotoelektrische Vorrichtung als ein phosphoreszierendes oder fluoreszierendes Hostmaterial in einer Emissionsschicht verwendet wird.

16. Organische fotoelektrische Vorrichtung nach Anspruch 11, wobei die Verbindung für eine organische fotoelektrische Vorrichtung als ein fluoreszierendes blaues Dotierstoffmaterial in einer Emissionsschicht verwendet wird.

17. Organische fotoelektrische Vorrichtung nach Anspruch 11, wobei die organische fotoelektrische Vorrichtung ausgewählt ist aus der Gruppe bestehend aus einer organischen Leuchtdiode, einer organischen Solarzelle, einem organischen Transistor, einer organischen Fotoleitertrommel und einer organischen Speichervorrichtung.

18. Displayvorrichtung mit der organischen fotoelektrischen Vorrichtung nach Anspruch 11.

## Revendications

1. Composé pour un dispositif photoélectrique organique représenté par les formules chimiques 1 ou 2 suivantes : 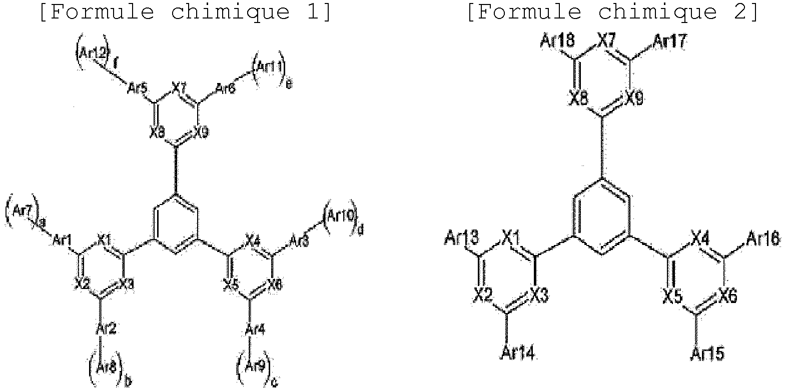 dans lequel, dans les formules chimiques 1 et 2,
X1 à X9 sont identiques ou différents et représentent indépendamment N ou CR, R étant choisi dans le groupe constitué par l'hydrogène, un groupe alkyle en C₁ à C₃₀, et un groupe aryle en C₆ à C₃₀,
au moins deux de X1 à X3 représentent N, au moins un de X4 à X6 représente N, et au moins un de X7 à X9 représente N,
dans lequel, dans la formule chimique 1,
Ar1 à Ar6 sont identiques ou différents et sont indépendamment choisis dans le groupe constitué par un groupe arylène en C₆ à C₃₀ substitué ou non substitué, un groupe hétéroarylène en C₃ à C₃₀ substitué ou non substitué, un groupe arylaminylène en C₆ à C₃₀ substitué ou non substitué, un groupe carbazolylène substitué ou non substitué, et un groupe fluorénylène substitué ou non substitué,
Ar7 à Ar12 sont identiques ou différents et sont indépendamment choisis dans le groupe constitué par un groupe aryle en C₆ à C₃₀ substitué ou non substitué ou un groupe hétéroaryle en C₃ à C₃₀ substitué ou non substitué, et
a, b, c, d, e et f sont identiques ou différents et représentent indépendamment un entier allant de 1 à 2,
dans lequel, dans la formule chimique 2,
Ar13 à Ar18 sont identiques ou différents et sont indépendamment choisis dans le groupe constitué par un groupe aryle en C₆ à C₃₀ substitué ou non substitué, un groupe hétéroaryle en C₃ à C₃₀ substitué ou non substitué, un groupe arylamine en C₆ à C₃₀ substitué ou non substitué, un groupe carbazolyle substitué ou non substitué, et un groupe fluorényle substitué ou non substitué.

2. Composé pour un dispositif photoélectrique organique de la revendication 1, dans lequel au moins deux de X4 à X6 représentent N.

3. Composé pour un dispositif photoélectrique organique de la revendication 1,
le composé pour un dispositif photoélectrique organique représenté par la formule chimique 1 ou 2 ci-dessus étant
un composé où X2, X3, X5, X6 et X7 représentent N, ou un composé où X2, X3, X5, X6 et X9 représentent N.

4. Composé pour un dispositif photoélectrique organique de la revendication 1,
le composé pour un dispositif photoélectrique organique représenté par la formule chimique 1 ou 2 ci-dessus étant choisi dans le groupe constitué par
un composé où X2, X3, X5, X6, X7 et X9 représentent N ;
un composé où X2, X3, X5, X6, X8 et X9 représentent N ;
un composé où X1, X3, X4, X5, X8 et X9 représentent N ; et
un composé où X1, X3, X4, X5, X7 et X9 représentent N.

5. Composé pour un dispositif photoélectrique organique de la revendication 1,
le composé pour un dispositif photoélectrique organique représenté par la formule chimique 1 ou 2 ci-dessus étant
un composé où X2, X6, X7 et X9 représentent N ou
un composé où X3, X5, X7 et X9 représentent N.

6. Composé pour un dispositif photoélectrique organique de la revendication 1,
le composé pour un dispositif photoélectrique organique représenté par la formule chimique 1 ou 2 ci-dessus étant
un composé où X2, X6, X7, X8 et X9 représentent N ou
un composé où X3, X5, X7, X8 et X9 représentent N.

7. Composé pour un dispositif photoélectrique organique de la revendication 1,
le composé pour un dispositif photoélectrique organique représenté par la formule chimique 1 ou 2 ci-dessus étant
un composé où X2, X3, X5, X6, X7, X8 et X9 représentent N ou
un composé où X1, X3, X4, X5, X7, X8 et X9 représentent N.

8. Composé pour un dispositif photoélectrique organique de la revendication 1,
dans lequel, dans la formule chimique 1,
Ar7 à Ar12 sont identiques ou différents et sont indépendamment choisis dans le groupe constitué par un groupe phényle, un groupe biphényle, un groupe terphényle, un groupe stilbényle, un groupe naphtyle, un groupe anthracényle, un groupe phénanthrényle, un groupe pyrényle, et un groupe pérylényle, et
Ar1 à Ar6 sont identiques ou différents et sont indépendamment choisis dans le groupe constitué par un groupe phénylène, un groupe biphénylène, un groupe terphénylène, un groupe stilbénylène, un groupe naphtylène, un groupe anthracénylène, un groupe phénanthrénylène, un groupe pyrénylène, et un groupe pérylénylène, et
dans la formule chimique 2,
Ar13 à Ar18 sont identiques ou différents et sont indépendamment choisis dans le groupe constitué par un groupe phényle, un groupe biphényle, un groupe terphényle, un groupe stilbényle, un groupe naphtyle, un groupe anthracényle, un groupe phénanthrényle, un groupe pyrényle, et un groupe pérylényle.

9. Composé pour un dispositif photoélectrique organique de la revendication 1,
dans lequel, dans la formule chimique 1,
Ar7 à Ar12 sont identiques ou différents et sont indépendamment choisis dans le groupe constitué par un groupe thiophényle, un groupe furanyle, un groupe pyrrolyle, un groupe imidazolyle, un groupe thiazolyle, un groupe oxazolyle, un groupe oxadiazolyle, un groupe triazolyle, un groupe pyridinyle, un groupe pyridazinyle, un groupe quinolinyle, un groupe isoquinolinyle, un groupe acridinyle, un groupe imidazopyridinyle, un groupe imidazopyrimidinyle, un groupe benzoquinolinyle, et un groupe phénanthrolinyle, et
dans la formule chimique 2,
Ar13 à Ar18 sont identiques ou différents et sont indépendamment choisis dans le groupe constitué par un groupe thiophényle, un groupe furanyle, un groupe pyrrolyle, un groupe imidazolyle, un groupe thiazolyle, un groupe oxazolyle, un groupe oxadiazolyle, un groupe triazolyle, un groupe pyridinyle, un groupe pyridazinyle, un groupe quinolinyle, un groupe isoquinolinyle, un groupe acridinyle, un groupe imidazopyridinyle, un groupe imidazopyrimidinyle, un groupe benzoquinolinyle, et un groupe phénanthrolinyle.

10. Composé pour un dispositif photoélectrique organique représenté par une des formules chimiques 3 à 33 suivantes :

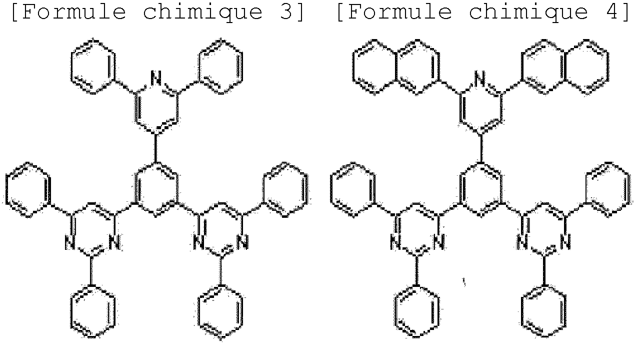

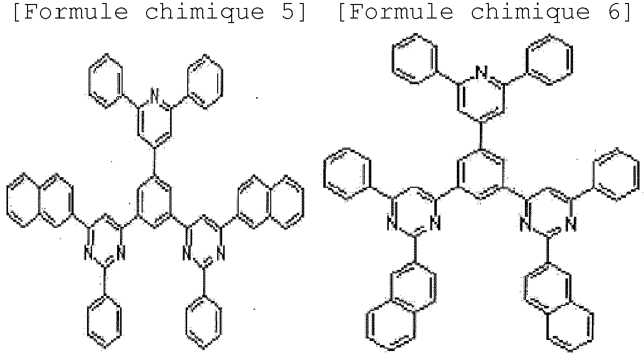

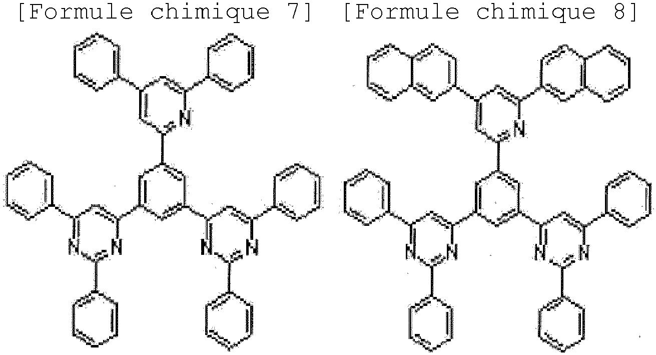

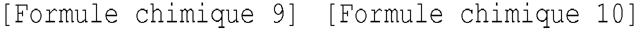

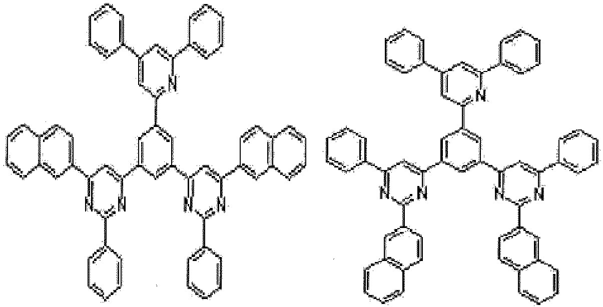

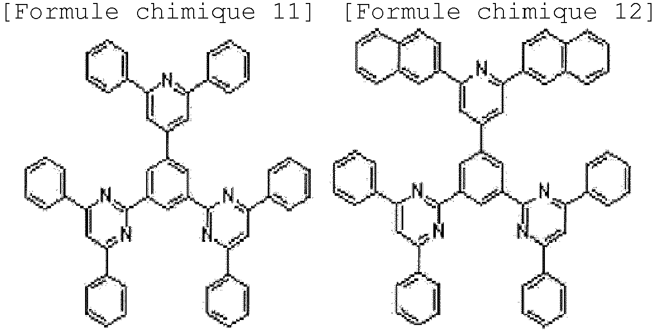

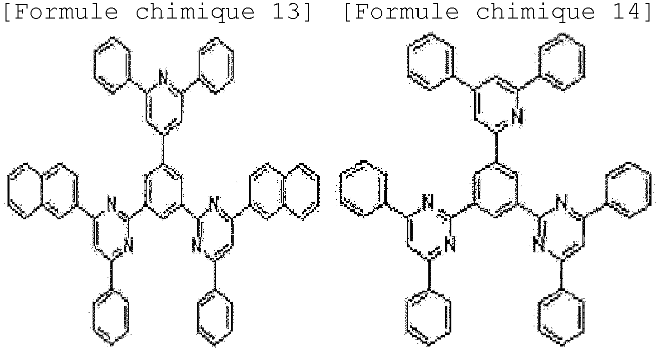

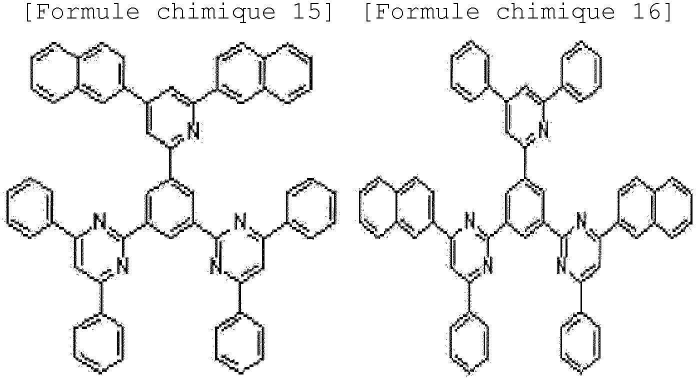

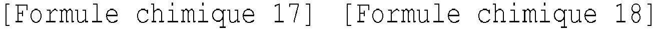

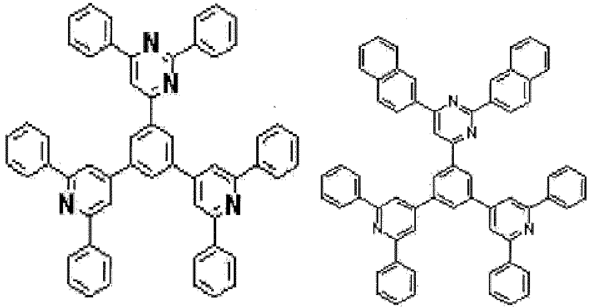

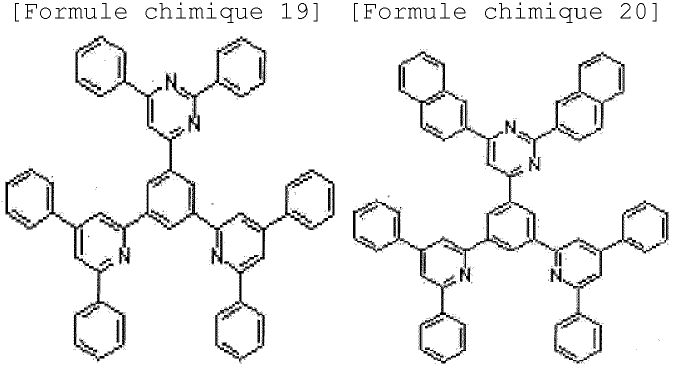

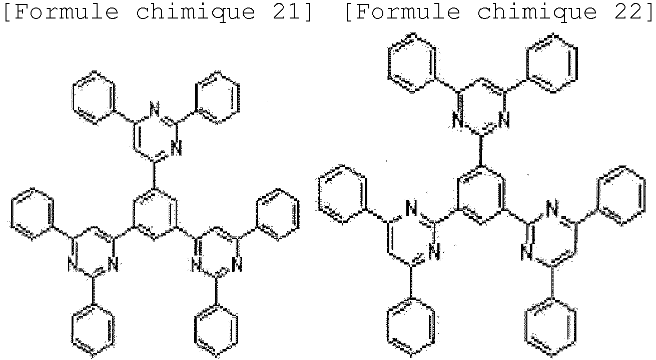

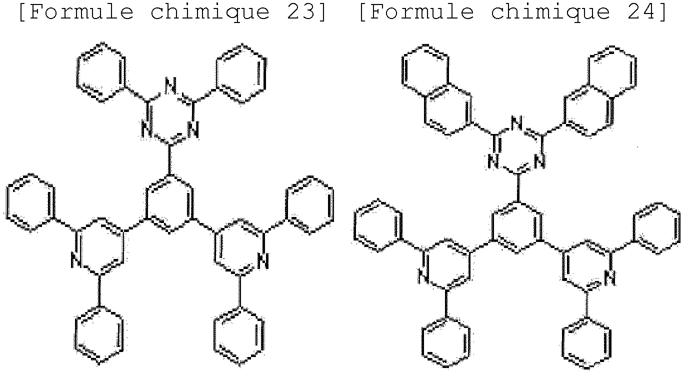

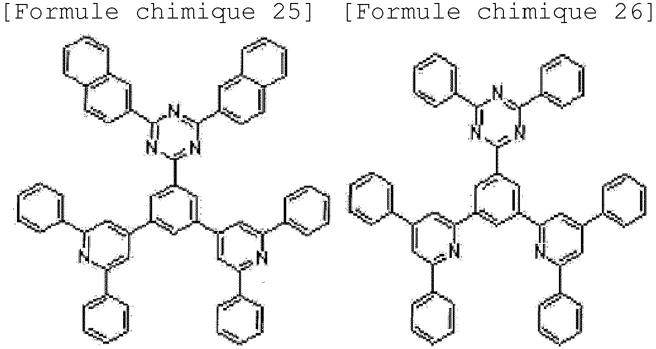

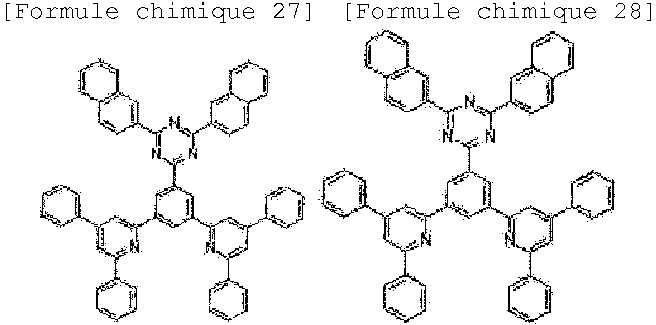

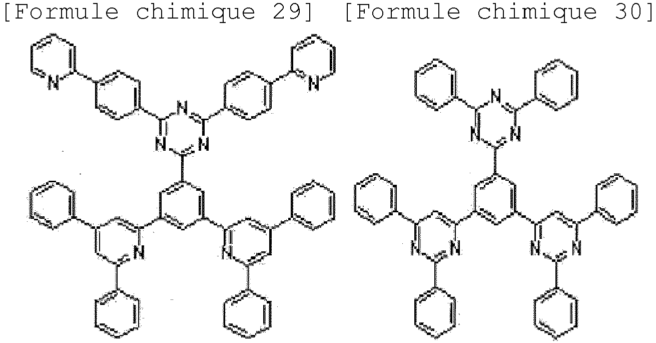

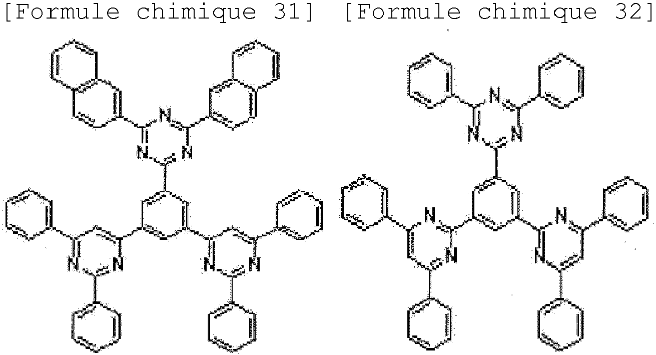

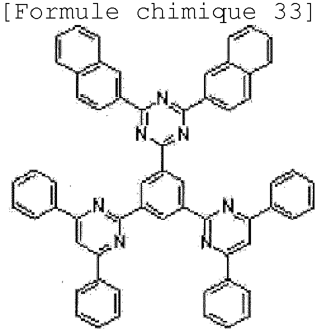

11. Dispositif photoélectrique organique comprenant une anode, une cathode, et au moins une ou plusieurs couches minces organiques entre l'anode et la cathode, au moins une des couches minces organiques comprenant le composé pour un dispositif photoélectrique organique selon une des revendications 1 à 10.

12. Dispositif photoélectrique organique de la revendication 11, dans lequel la couche mince organique est choisie dans le groupe constitué par une couche d'émission, une couche de transport de trous (HTL), une couche d'injection de trous (HIL), une couche de transport d'électrons (ETL), une couche d'injection d'électrons (EIL), une couche de blocage de trous, et une combinaison de celles-ci.

13. Dispositif photoélectrique organique de la revendication 11, le composé pour un dispositif photoélectrique organique étant incorporé dans une couche de transport d'électrons (ETL) ou une couche d'injection d'électrons (EIL).

14. Dispositif photoélectrique organique de la revendication 11, le composé pour un dispositif photoélectrique organique étant incorporé dans une couche d'émission.

15. Dispositif photoélectrique organique de la revendication 11, le composé pour un dispositif photoélectrique organique étant utilisé comme un matériau hôte phosphorescent ou fluorescent dans une couche d'émission.

16. Dispositif photoélectrique organique de la revendication 11, le composé pour un dispositif photoélectrique organique étant utilisé comme un matériau dopant fluorescent bleu dans une couche d'émission.

17. Dispositif photoélectrique organique de la revendication 11, le dispositif photoélectrique organique étant choisi dans le groupe constitué par une diode électroluminescente organique, une cellule solaire organique, un transistor organique, un tambour photoconducteur organique, et un dispositif de mémoire organique.

18. Dispositif d'affichage comportant le dispositif photoélectrique organique selon la revendication 11.
